# EUROPEAN PATENT APPLICATION

(11) **EP 4 618 701 A1**
(43) Date of publication of application: **17.09.2025**
(21) Application number: 25719263.3
(22) Date of filing: 16.01.2025
(51) Int. Cl.: H05K 3/40, H05K 1/11

(54) **METHOD FOR MANUFACTURING GLASS SUBSTRATE HAVING CONDUCTIVE VIA, METAL PASTE FOR FORMING THROUGH-GLASS VIA, AND GLASS SUBSTRATE HAVING CONDUCTIVE VIA**

(30) Priority: 31.01.2024 JP 2024013073
(71) Applicant: Resonac Corporation, Tokyo 105-7325 (JP)
(72) Inventor: EJIRI, Yoshinori, Tokyo 105-7325 (JP); SAKAMOTO, Masumi, Tokyo 105-7325 (JP); SHIMIZU, Chiaki, Tokyo 105-7325 (JP); OIKAWA, Futoshi, Tokyo 105-7325 (JP); URAGAMI, Hiroshi, Tokyo 105-7325 (JP); KAI, Seiji, Tokyo 105-7325 (JP); MORIJIRI, Tomoki, Tokyo 105-7325 (JP); KIKUCHI, Naoyuki, Tokyo 105-7325 (JP); URASHIMA, Kosuke, Tokyo 105-7325 (JP); KURAHASHI, Shunsuke, Tokyo 105-7325 (JP)
(74) Representative: Hoffmann Eitle
(86) International application number: PCT/JP2025/001210
(87) International publication number: WO 2025/164337

(57) **Abstract**

A method for manufacturing a conductive via-containing glass substrate includes: a step a of preparing a glass substrate provided with a hole and providing a metal paste part containing metal particles and a volatile solvent to fill the inside of the hole and cover at least a surface surrounding the hole of the glass substrate; a step b of heating the metal paste part to remove a part of the volatile solvent; a step c of removing a part of the metal paste part after heating to expose the surface to form a conductive via precursor in the hole, the conductive via precursor containing the metal particles and a residue of the volatile solvent and having a planarized exposed surface; and a step d of firing the conductive via precursor, in which the metal particles include first metal particles having a volume average particle diameter of 0.8 µm or more and second metal particles having a volume average particle diameter of 0.5 µm or less, a metal particle concentration of the metal paste part provided in the step a is 95.0% by mass or more, and a content of the second metal particles in the metal paste part provided in the step a is 50% by mass or less based on a total amount of the metal particles.

The method for manufacturing a conductive via-containing glass substrate is also useful as a technique for reducing an environmental load caused by plating.

## Description

### Technical Field

The present invention relates to a method for manufacturing a conductive via-containing glass substrate, a metal paste, and a conductive via-containing glass substrate.

### Background Art

In recent years, in order to reduce the size, increase the functionality, and achieve the integration of electronic devices or components, a three-dimensional mounting technology has attracted attention, in which glass substrates arranged vertically are electrically connected to each other via an electrode, which is called a through glass via (TGV), and semiconductor chips are stacked in a vertical direction (height direction) at a high density.

As a technique for forming a through electrode, for example, it is disclosed in Patent Literature 1 that a method for manufacturing a semiconductor device that has a through glass via includes a step of performing copper plating on a blind-via formed on a glass substrate by electroplating using a specific copper plating solution. In addition,

Patent Literature 2 proposes a method for manufacturing a semiconductor device including a step of forming a hollow through electrode on a glass substrate by electrolytic copper plating, and further filling the electrode with a mixture of a metal powder and a resin material.

### Citation List

### Patent Literature

Patent Literature 1: Japanese Unexamined Patent Publication No. 2019-134016
Patent Literature 2: Japanese Unexamined Patent Publication No. 2016-96262

### Summary of Invention

### Technical Problem

Recently, an inner diameter of a through-hole has been minimized along with the reduction of a glass substrate for coping with the miniaturization of electronic devices or components, and it is necessary to form a conductive via having sufficient conductivity even in such a through-hole. In addition, a wiring may be further provided on a surface of the substrate in which the conductive via is formed by plating or other processes, and even in this case, it is necessary to exhibit a sufficiently low connection resistance value.

In addition, recently, an increase in speed of a signal, a reduction in size of a substrate, and a reduction in power consumption due to a reduction in transmission distance have been promoted, and further improvement in connection reliability has been required more than ever. Due to such circumstances, a conductive via-containing substrate on which the above-described wiring is formed (wiring board) is required to be excellent in not only conductivity but also a characteristic that a connection resistance value is less likely to increase even when subjected to a temperature change (hereinafter, also referred to as "connection reliability").

However, it is clear from the study of the present inventors that in a glass substrate including a through glass via of a copper plating coating, cracks may occur in the periphery of the through glass via due to the thermal history of a temperature cycle, and the connection resistance value may increase. As a method for preventing the glass substrate from being cracked, it is considered to change the material of the glass substrate or reinforce the glass substrate with a resin, but it cannot be said to be a sufficient method for achieving both a low connection resistance value and excellent connection reliability.

Therefore, an object of the present invention is to provide a method for manufacturing a conductive via-containing glass substrate, which has a through glass via (TGV), can exhibit a sufficiently low connection resistance value even after wiring formation, and can provide a wiring board obtained with excellent connection reliability, a metal paste that can be used for formation of a through glass via, and a conductive via-containing glass substrate.

### Solution to Problem

As a result of intensive studies to achieve the above-described object, the present inventors have found that a factor of increasing the connection resistance value after wiring formation is a low planarity (or smoothness) of conductive vias at a surface of a conductive via-containing substrate (in other words, the step height between a conductive via part and the substrate surface is large). As a result of studying a method for reducing the above-described step height based on this finding, the present inventors have found that a sufficiently low connection resistance value can be obtained by forming a conductive via by a specific step using a metal paste containing specific metal particles and a volatile solvent even in a case where a wiring connected to the conductive via is further formed, and the obtained wiring board has excellent connection reliability without the occurrence of cracks in the glass substrate even after a temperature cycle reliability test, and have completed the present invention.

That is, one aspect of the present invention relates to a method for manufacturing a conductive via-containing substrate described below.
**[1]** A method for manufacturing a conductive via-containing glass substrate, the method including: a step a of preparing a glass substrate provided with a hole and providing a metal paste part containing metal particles and a volatile solvent to fill the inside of the hole and cover at least a surface surrounding the hole of the glass substrate; a step b of heating the metal paste part to remove a part of the volatile solvent; a step c of removing a part of the metal paste part after heating to expose the surface to form a conductive via precursor in the hole, the conductive via precursor containing the metal particles and a residue of the volatile solvent and having a planarized exposed surface; and a step d of firing the conductive via precursor, in which the metal particles include first metal particles having a volume average particle diameter of 0.8 µm or more and second metal particles having a volume average particle diameter of 0.5 µm or less, a metal particle concentration of the metal paste part provided in the step a is 95.0% by mass or more, and a content of the second metal particles in the metal paste part provided in the step a is 50% by mass or less based on a total amount of the metal particles.

According to the above manufacturing method, it is possible to provide, through the step a, the metal paste part containing the volatile solvent and having the above-described specific metal particle configuration, and then through the step b and the step c, to achieve both the good filling of the inside of the hole and the formation of the conductive via precursor that is less likely to undergo volume shrinkage by firing, and it is possible to form, through the step d, the conductive via with excellent conductivity, in which the occurrence of cracks and voids is sufficiently minimized while the step height with respect to the substrate surface is sufficiently reduced. As a result, it is possible to obtain a conductive via-containing substrate exhibiting a sufficiently low connection resistance value even after wiring formation, and further, in the conductive via-containing substrate on which the wiring is formed (wiring board), the occurrence of cracks in the glass substrate is suppressed even after a temperature cycle reliability test, and excellent connection reliability can be achieved.

The present inventors estimate the reason why the occurrence of cracks in the glass substrate can be suppressed as follows. First, stress due to the through glass via is considered as a main factor of the occurrence of cracks. For example, it is known that the stress of the copper plating coating has a high Young's modulus of about 100 GPa as described in the following reference literature.

Reference Literature: Measurement of Young's modulus of thin film for electronic device by precision three-point bending method, Journal of Japan Society of Mechanical Engineers (A), Vol. 77, No. 773 (2011-1), P190

According to the manufacturing method of [1], it is considered that, when the specific conductive via precursor is fired, a sintered body having a Young's modulus of half or less of a copper plating coating can be formed, and stress due to the through glass via is relaxed. As a result, the present inventors presume that this makes it possible to suppress cracks of the glass substrate in the peripheral portion of the through glass via and to achieve both a low connection resistance value and excellent connection reliability.
[2] The method for manufacturing a conductive via-containing substrate according to [1], in which the first metal particles and the second metal particles are copper particles.
[3] The method for manufacturing a conductive via-containing substrate according to [1] or [2], in which the first metal particles include flaky copper particles.

In addition, another aspect of the present invention relates to the following metal paste.

[4] A metal paste for forming a through glass via, the metal paste containing: metal particles; and a volatile solvent, in which a content of the metal particles is 95.0% by mass or more based on a total amount of the metal paste, the metal particles include first metal particles having a volume average particle diameter of 0.8 µm or more and second metal particles having a volume average particle diameter of 0.5 µm or less, and a content of the second metal particles is 50% by mass or less based on a total amount of the metal particles.

[5] The metal paste for forming a through glass via according to

[4], in which the first metal particles and the second metal particles are copper particles.

[6] The metal paste for forming a through glass via according to [4] or [5], in which the first metal particles include flaky copper particles.

According to the metal paste, the sufficient printability can be obtained, and the metal paste part can be efficiently formed in the method for manufacturing a conductive via-containing glass substrate.

In addition, another aspect of the present invention relates to the following conductive via-containing glass substrate.

[7] A conductive via-containing glass substrate including: a glass substrate having a through-hole; and a conductive via provided in the through-hole, in which the conductive via contains a sintered body of the metal paste according to any one of [4] to [6].

### Advantageous Effects of Invention

According to the present invention, it is possible to provide a method for manufacturing a conductive via-containing glass substrate, which has a through glass via (TGV), can exhibit a sufficiently low connection resistance value even after wiring formation, and can provide a wiring board obtained with excellent connection reliability, a metal paste that can be used for formation of a through glass via, and a conductive via-containing glass substrate.

### Brief Description of Drawings

FIG. 1 is a schematic view illustrating an example of a method for manufacturing a conductive via-containing glass substrate according to the present embodiment.
FIG. 2 is a schematic view illustrating an example of the method for manufacturing a conductive via-containing glass substrate according to the present embodiment.
FIG. 3 is a schematic view illustrating an example of the method for manufacturing a conductive via-containing glass substrate according to the present embodiment.
FIG. 4 is a schematic view illustrating an example of a method for forming a wiring.
FIG. 5 is a schematic view illustrating a test piece.
FIG. 6 is a view illustrating a cross-section image of a conductive via in a conductive via-containing glass substrate produced in Example 1.
FIG. 7 is a view illustrating an appearance and a cross section of a wiring board produced in Example 1.
FIG. 8 is a view illustrating a surface of a wiring board produced in Example 12 after a temperature cycle reliability test.
FIG. 9 is a view illustrating a surface of a wiring board produced in Comparative Example 7 after a temperature cycle reliability test.

### Description of Embodiments

Hereinafter, embodiments of the present invention will be described in detail with reference to the drawings. The present invention is not limited to the following embodiments. In the drawings, the same or corresponding parts are denoted by the same reference numerals, and redundant description will be omitted.

### <Metal Paste>

A metal paste of the present embodiment contains metal particles and a volatile solvent, and a content of the metal particles is 95.0% by mass or more based on the total amount of the metal paste. The metal paste of the present embodiment can be used for forming a metal paste part in a method for manufacturing a conductive via-containing glass substrate described below, and a through glass via can be formed.

The content of the metal particles in the metal paste of the present embodiment may be 95.2% by mass or more, 95.5% by mass or more, 95.7% by mass or more, or 96% by mass or more, may be 98% by mass or less, 97% by mass or less, or 96.5% by mass or less, and may be 95.0 to 98% by mass, 95.2 to 97% by mass, or 95.7 to 96.5% by mass, based on the total amount of the metal paste.

### [Metal Particles]

Examples of the metal particles include particles of nickel, silver, copper, gold, palladium, platinum, solder, and other metals. The metal particles may contain a plurality of metals such as silver-coated copper particles. In a case where the metal paste contains copper particles, it is easy to obtain a conductor having sufficient conductivity and a resistance value that does not easily increase even under temperature changes, and a base having a through electrode with sufficient conductivity and excellent connection reliability. In the present embodiment, the metal particles include first metal particles having a volume average particle diameter of 0.8 µm or more and second metal particles having a volume average particle diameter of 0.5 µm or less.

In the present specification, the volume average particle diameter of the particles (hereinafter, may be referred to as "average particle diameter") means a 50% volume average particle diameter (D50). In a case where the volume average particle diameter of the metal particles is

determined, the volume average particle diameter can be determined by a method for dispersing metal particles as a raw material in a dispersion medium such as water or alcohol, and measuring the dispersion medium with a laser diffraction/scattering particle size distribution analyzer, or other ways.

The first metal particles and the second metal particles may be copper particles from the viewpoints of reduction in resistance, securing of sulfur migration resistance, and ease of wiring formation. The present embodiment will be described in detail with an example in which the first metal particles are copper particles (hereinafter, referred to as "first copper particles") and the second metal particles are copper particles (hereinafter, referred to as "second copper particles").

### (First Copper Particles)

The average particle diameter of the first copper particles may be 0.8 µm or more, 1.0 µm or more, 2.0 µm or more, or 3.0 µm or more from the viewpoint of improving the sintering density in the holes (for example, through-holes or blind-holes) of the substrate and minimizing voids and cracks occurring in the holes, the average particle diameter of the first copper particles may be 10 µm or less, 8.0 µm or less, 5.0 µm or less, or 4.0 µm or less, for example, from the viewpoint of minimizing clogging of the particles in a fine via having an inner diameter of 100 µm or less and improving the filling property, and the average particle diameter of the first copper particles may be 0.8 µm to 4.0 µm, 1.0 µm to 3.5 µm, or 1.2 µm to 3.0 µm from the viewpoint of minimizing voids and cracks and minimizing clogging of the particles in the fine via. A ratio (DC1/DH) of an average particle diameter DC1 of the first copper particles to an inner diameter DH of the holes may be 0.01 or more, 0.03 or more, or 0.04 or more from the viewpoint of suppressing clogging of the particles in the fine vias and improving the filling property, and may be 0.15 or less, 0.1 or less, or 0.05 or less from the viewpoint of suppressing voids and cracks by reducing shrinkage due to firing. In addition, from the above viewpoints, the ratio (DC1/DH) may be 0.01 to 0.15 or 0.03 to 0.1.

The shape of the first copper particles may be, for example, a spherical shape, an agglomerated shape, a needle shape, a flat shape (flake shape), a substantially spherical shape, or other shapes. The first metal particles may be an aggregate of copper particles having these shapes. The metal paste of the present embodiment can contain spherical copper particles as the first copper particles from the viewpoint of reducing the step height between the conductive via part to be formed and the substrate surface to minimize the fluctuation in connection resistance even after a reliability test (for example, a temperature cycle test).

In the first copper particles, the content ratio of particles having an aspect ratio of 2 or less, such as spherical particles, may be 40% by mass or more, 50% by mass or more, 60% by mass or more, 80% by mass or more, or 100% by mass, and 40 to 90% by mass, 50 to 80% by mass, or 60 to 70% by mass, from the viewpoint of improving the printability of the metal paste. The aspect ratio (major axis/minor axis) of a particle can be determined, for example, by observing an SEM image of the particle and measuring the major axis and the minor axis (for example, the thickness).

In addition, the metal paste of the present embodiment may contain flaky copper particles as the first copper particles from the viewpoint of suppressing voids and cracks by reducing shrinkage due to firing, and may contain spherical copper particles and flaky copper particles from the viewpoint of reducing a viscosity of the metal paste to improve the filling property into fine vias and suppressing voids and cracks by reducing shrinkage due to firing. When spherical copper particles and flaky copper particles are used in combination, a mass ratio thereof (spherical copper particles)/(flaky copper particles) may be 1 to 9, 1.2 to 2.5, or 1.4 to 4.

The flaky copper particles may have an aspect ratio of 1.5 or more, 2 or more, or 3 or more.

When spherical copper particles having an aspect ratio of 2 or less and flaky copper particles having an aspect ratio of more than 2 are used in combination, a mass ratio thereof (spherical copper particles)/(flaky copper particles) may be 0.6 to 9, 1.0 to 4.0, or 1.5 to 2.4.

The first copper particles may be prepared by a chemical reduction method, an atomization method, an electrolytic method, a pulverization method, a plasma rotary electrode method, a homogeneous liquid spraying method, a heat treatment method, or the like, and may be a wet copper powder or an atomized copper powder from the viewpoint of easily obtaining a uniform diameter and improving the dispersibility of the metal paste.

The first copper particles may contain a wet copper powder. In this case, a conductive via having excellent conductivity is easily obtained. Such an effect is considered to be obtained based on the properties of the wet copper powder being easily bonded to the copper particles blended as the second copper particles. The wet copper powder may have a D90/D50 of 1.5 or less.

In addition, the copper particles can contain a wet copper powder and an atomized copper powder. In this case, it is easy to achieve that the printability of the metal paste is improved, and the step height between the conductive via part to be formed and the substrate surface is reduced to minimize the fluctuation in connection resistance even after a reliability test (for example, a temperature cycle test). The reason why such an effect can be obtained is presumed as follows. That is, it is considered that since the wet copper powder that is easily bonded to the second copper particles and that has a uniform particle diameter and the atomized copper powder that has a wide particle size distribution coexist, particles of the wet copper powder are bonded to the second copper particles while bonding between particles of the atomized copper powder. As a result, it is possible to achieve the formation of a strong sintered body based on the close-packed structure, and the reduction of shrinkage during sintering to minimize the occurrence of voids and cracks and minimize recesses. The atomized copper powder may have D90/D50 of 1.6 or more, 1.7 or more, or 1.8 or more.

When the first copper particles contain the wet copper powder and the atomized copper powder, a content ratio of the wet copper powder may be more than 0 parts by mass and less than 100 parts by mass, or may be 20 to 80 parts by mass, with respect to 100 parts by mass of the total amount of the wet copper powder and the atomized copper powder.

As the first copper particles, commercially available copper particles can be used. Examples of the commercially available first copper particles include 1050Y (manufactured by MITSUI MINING & SMELTING CO., LTD., trade name, average particle diameter (D50): 0.81 µm, D90: 1.1 µm, spherical shape, wet copper powder), 1100Y (manufactured by MITSUI MINING & SMELTING CO., LTD., trade name, average particle diameter (D50): 1.1 µm, D90: 1.6 µm, spherical shape, wet copper powder), 1200Y (manufactured by MITSUI MINING & SMELTING CO., LTD., trade name, average particle diameter (D50): 2.1 µm, D90: 3.1 µm, spherical shape, wet copper powder), 1300Y (manufactured by MITSUI MINING & SMELTING CO., LTD., trade name, average particle diameter (D50): 3.5 µm, D90: 5 µm, spherical shape, wet copper powder), 1100YP (manufactured by MITSUI MINING & SMELTING CO., LTD., trade name, average particle diameter (D50): 1.4 µm, D90: 2.3 µm, flat shape, wet copper powder), 1200YP (manufactured by MITSUI MINING & SMELTING CO., LTD., trade name, average particle diameter (D50): 3.1 µm, D90: 5.3 µm, flat shape, wet copper powder), MA-C02K (manufactured by MITSUI MINING & SMELTING CO., LTD., trade name, average particle diameter (D50): 1.8 µm, D90: 3.6 µm, spherical shape, atomized copper powder), MA-C025K (manufactured by MITSUI MINING & SMELTING CO., LTD., trade name, average particle diameter (D50): 2.4 µm, D90: 5.2 µm, spherical shape, atomized copper powder), and MA-C03K (manufactured by MITSUI MINING & SMELTING CO., LTD., trade name, average particle diameter (D50): 3.4 µm, D90: 6.3 µm, spherical shape, atomized copper powder).

The first copper particles may be treated with a surface treatment agent from the viewpoint of dispersion stability and oxidation resistance. The surface treatment agent may be removed during wiring formation (during sintering of copper particles). Examples of such a surface treatment agent include aliphatic carboxylic acids such as palmitic acid, stearic acid, arachidic acid, and oleic acid; aromatic carboxylic acids such as terephthalic acid, pyromellitic acid, and o-phenoxybenzoic acid; aliphatic alcohols such as cetyl alcohol, stearyl alcohol, isobornyl cyclohexanol, and tetraethylene glycol; aromatic alcohol such as p-phenylphenol; alkylamines such as octylamine, dodecylamine, and stearylamine; aliphatic nitriles such as stearonitrile and decanenitrile; silane coupling agents such as alkylalkoxysilane; polymer treatment agents such as polyethylene glycol, polyvinyl alcohol, polyvinyl pyrrolidone, and silicone oligomers, and other surface treatment agents. The surface treatment agents may be used alone, or may be used in combination of two or more kinds.

A treatment amount of the surface treatment agent may be an amount of one or more molecular layers on the particle surface. The amount of such a surface treatment agent varies depending on the specific surface area of the first copper particles, the molecular weight of the surface treatment agent, and the minimum coating area of the surface treatment agent. The treatment amount of the surface treatment agent is usually 0.001 mass% or more.

The treatment amount of the surface treatment agent can be calculated from the number (n) of molecular layers attached to the surface of the first copper particle, the specific surface area (Aₚ) (unit: m²/g) of the first copper particles, the molecular weight (Mₛ) (unit: g/mol) of the surface treatment agent, the minimum coating area (S_{S}) (unit: m²/unit) of the surface treatment agent, and the Avogadro's number (N_{A}) (6.02 × 10²³). Specifically, the treatment amount of the surface treatment agent is calculated according to the expression of the treatment amount (mass%) of the surface treatment agent = {(n × Aₚ × Mₛ)/(S_{S} × N_{A} + n × Aₚ × Mₛ)} × 100%.

The specific surface area of the first copper particle can be calculated by measuring the dried copper particle by the BET specific surface area measurement method. In a case where the surface treatment agent is a linear saturated fatty acid, the minimum coating area of the surface treatment agent is 2.05 × 10⁻¹⁹ m²/1 molecule. For other surface treatment agents, for example, the minimum coating area can be measured by calculation from a molecular model or the method described in "Chemistry and Education" (Katsuhiro Ueda, Sumio Inafuku, and Iwao Mori, 40 (2), 1992, pp 114-117). An example of a method for quantifying the surface treatment agent will be described. The surface treatment agent can be identified using the dry powder obtained by removing the dispersion medium from the metal paste by a thermal desorption gas-gas chromatograph mass spectrometer, thereby enabling the number of carbon atoms and the molecular weight of the surface treatment agent to be determined. The proportion of carbon content in the surface treatment agent can be analyzed by carbon content analysis. Examples of the carbon content analysis method include a high-frequency induction heating furnace combustion-infrared absorption method. The amount of the surface treatment agent can be calculated from the number of carbons, the molecular weight, and the carbon content ratio of the surface treatment agent that is identified by the expression described above.

### (Second Copper Particles)

The average particle diameter of the second copper particles may be 0.5 µm or less, 0.4 µm or less, 0.3 µm or less, or 0.2 µm or less from the viewpoint of sinterability, may be 0.01 µm or more, 0.03 µm or more, 0.05 µm or more, 0.08 µm or more, or 0.1 µm or more from the viewpoint of reducing synthesis cost, good dispersibility, reducing the use amount of a surface treatment agent, and may be 0.1 µm to 0.3 µm, 0.12 µm to 0.28 µm, or 0.15 µm to 0.25 µm from the viewpoint of obtaining sinterability at a low temperature and good dispersibility in a paste.

The second copper particles can act as copper particles that suitably bond the first copper particles. In addition, the second copper particles are more excellent in sinterability than the first copper particles, and can have a function of promoting sintering of the copper particles. For example, the copper particles can be sintered at a lower temperature as compared with the case where the first copper particles are used alone as the copper particles.

The second copper particles may be a wet copper powder prepared by a chemical reduction method.

The shapes of the second copper particles may be, for example, a spherical shape, a lump shape, a needle shape, a flat shape (flake shape), a substantially spherical shape, and the like. The second copper particles may be an aggregate of copper particles having these shapes. From the viewpoint of the dispersibility and the filling property, the shapes of the second copper particles may be a spherical shape, a substantially spherical shape, and a flat shape (flake shape), and from the viewpoint of the flammability, the mixing property with the first copper particles, and the like, the shapes of the second copper particles may be a spherical shape or a substantially spherical shape.

An aspect ratio of the second copper particles may be 5 or less, 4 or less, or 3 or less from the viewpoint of the dispersibility, the filling property, and the mixing property with the first copper particles.

As the second copper particles, synthesized or commercially available copper particles can be used. Examples of the second copper particles, which are commercially available, include CH0200L 1 (manufactured by MITSUI MINING & SMELTING CO., LTD., average particle diameter (D50): 200 nm, spherical) and Tn-Cu100 (manufactured by TAIYO NIPPON SANSO CORPORATION, average particle diameter (D50): 120 nm, spherical).

The second copper particles may be treated with a specific surface treating agent. Examples of the specific surface treatment agent include an organic acid having 8 to 16 carbon atoms. Examples of the organic acid having 8 to 16 carbon atoms include saturated fatty acids such as caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyltridecanoic acid, ethyldodecanoic acid, propylundecanoic acid, butyldecanoic acid, pentylnonanoic acid, hexyloctanoic acid, pentadecanoic acid, methyltetradecanoic acid, ethyltridecanoic acid, propyldodecanoic acid, butylundecanoic acid, pentyldecanoic acid, hexylnonanoic acid, palmitic acid, methylpentadecanoic acid, ethyltetradecanoic acid, propyltridecanoic acid, butyldodecanoic acid, pentylundecanoic acid, hexyldecanoic acid, heptylnonanoic acid, methylcyclohexanecarboxylic acid, ethylcyclohexanecarboxylic acid, propylcyclohexanecarboxylic acid, butylcyclohexanecarboxylic acid, pentylcyclohexanecarboxylic acid, hexylcyclohexanecarboxylic acid, heptylcyclohexanecarboxylic acid, octylcyclohexanecarboxylic acid, and nonylcyclohexanecarboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecenoic acid, hexadecenoic acid, palmitoleic acid, and sapienic acid; and aromatic carboxylic acids such as terephthalic acid, pyromellitic acid, o-phenoxybenzoic acid, methyl benzoic acid, ethyl benzoic acid, propyl benzoic acid, butyl benzoic acid, pentyl benzoic acid, hexyl benzoic acid, heptyl benzoic acid, octyl benzoic acid, and nonyl benzoic acid. The organic acid may be used alone or in combination of two or more kinds thereof. By combining such an organic acid with the second copper particles described above, the dispersibility of the second copper particles and the releasability of the organic acid during sintering tend to be compatible.

A treatment amount of the surface treatment agent may be an amount in which one molecular layer to three molecular layers are attached to the surface of the second copper particle. The amount of the surface treatment agent may be 0.07% by mass or more, 0.10% by mass or more, or 0.2% by mass or more, and may be 2.1% by mass or less, 1.6% by mass or less, or 1.1% by mass or less. The surface treatment amount of the second copper particles can be calculated by the above-described method for the first copper particles. The same applies to the specific surface area, the molecular weight of the surface treatment agent, and the minimum coating area of the surface treatment agent.

A content of the second metal particles in the metal paste is 50% by mass or less based on the total amount of the metal particles from the viewpoint of connection reliability, and may be 10 to 50% by mass or 20 to 40% by mass from the viewpoint of improving adhesion to an under metal layer by lowering a sintering temperature, reducing the porosity of the sintered body and suppressing shrinkage during sintering, and suppressing the occurrence of cracks.

The total content of the first copper particles and the second copper particles in the metal paste may be 100 parts by mass, 85 to 99.5 parts by mass, 90 to 99 parts by mass, or 95 to 98 parts by mass, given that the total mass of the metal particles is 100 parts by mass.

The content of each of the first copper particles and the second copper particles may be 50 to 90 parts by mass and 50 to 10 parts by mass, 55 to 85 parts by mass and 45 to 15 parts by mass, or 60 to 80 parts by mass and 40 to 20 parts by mass, with respect to a total of 100 parts by mass of the first copper particles and the second copper particles.

The metal paste of the present embodiment may contain metal particles other than the copper particles (hereinafter, also referred to as "other metal particles"). In this case, the other metal particles may be nickel particles, silver particles, gold particles, palladium particles, platinum particles, or solder particles. These can be contained singly or in combination of two or more kinds thereof. The average particle diameter of the other metal particles may be 0.01 µm or more, 0.03 µm or more, or 0.05 µm or more, and may be 5 µm or less, 3.0 µm or less, or 2.0 µm or less. An average particle diameter of the solder particles may be 1.0 µm or more, 1.5 µm or more, 2.0 µm or more, 3.0 µm or more, or 4.0 µm or more, and may be 15 µm or less, 10 µm or less, 8.0 µm or less, or 5.0 µm or less.

The content of the other metal particles may be 5 parts by mass or less, 3 parts by mass or less, 1 part by mass or less, or 0.8 parts by mass or less, given that the total mass of the copper particles is 100 parts by mass. The metal paste of the present embodiment may not contain solder particles as other metal particles.

### [Volatile Solvent]

Examples of the volatile solvent include monohydric and polyhydric alcohols such as pentanol, hexanol, heptanol, octanol, decanol, ethylene glycol, diethylene glycol, propylene glycol, butylene glycol (such as 1,3-butanediol), α-terpineol, and isobornyl cyclohexanol (MTPH); ethers such as ethylene glycol butyl ether, ethylene glycol phenyl ether, diethylene glycol methyl ether, diethylene glycol ethyl ether (ethyl carbitol), diethylene glycol butyl ether (such as diethylene glycol mono-n-butyl ether), diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, tripropylene glycol dimethyl ether; esters such as dimethyl phthalate, ethylene glycol ethyl ether acetate, ethylene glycol butyl ether acetate, propylene glycol diacetate, diethylene glycol ethyl ether acetate, diethylene glycol butyl ether acetate, dipropylene glycol methyl ether acetate (DPMA), ethyl lactate, butyl lactate, γ-butyrolactone, and propylene carbonate; acid amides such as N-methyl-2-pyrrolidone, N,N-dimethylacetamide, and N,N-dimethylformamide; aliphatic hydrocarbons such as cyclohexane, octane, nonane, decane, and undecane; aromatic hydrocarbons such as benzene, toluene, and xylene; mercaptans containing an alkyl group having 1 to 18 carbon atoms; and mercaptans containing a cycloalkyl group having 5 to 7 carbon atoms. Examples of the mercaptans containing an alkyl group having 1 to 18 carbon atoms include ethyl mercaptan, n-propyl mercaptan, i-propyl mercaptan, n-butyl mercaptan, i-butyl mercaptan, t-butyl mercaptan, pentyl mercaptan, hexyl mercaptan, and dodecyl mercaptan. Examples of the mercaptans containing a cycloalkyl group having 5 to 7 carbon atoms include cyclopentyl mercaptan, cyclohexyl mercaptan, and cycloheptyl mercaptan. The volatile solvent may be used alone or in combination of two or more kinds thereof.

The metal paste of the present embodiment may contain a solvent having a vapor pressure of 4 Pa or more and 30 Pa or less (hereinafter, also referred to as a "high vapor pressure solvent") at 20°C as a volatile solvent from the viewpoint of printability and reducing volume shrinkage before and after firing the conductive via precursor (for example, between step c of forming the conductive via precursor and step d of firing the conductive via precursor) to minimize voids and cracks. The high vapor pressure solvent may be used alone or in combination of two or more kinds thereof.

Examples of the high vapor pressure solvent include α-terpineol, 1,3-butanediol, ethyl carbitol, propylene glycol diacetate, and other high vapor pressure solvents.

The metal paste of the present embodiment may contain a solvent having a vapor pressure of less than 4 Pa (hereinafter, also referred to as a "low vapor pressure solvent") at 20°C as a volatile solvent from the viewpoint of minimizing powderization by drying associated with solvent evaporation during printing or paste production. The low vapor pressure solvent may be used alone or in combination of two or more kinds thereof.

Examples of the low vapor pressure solvent include isobornyl cyclohexanol (MTPH), dimethyl phthalate, diethylene glycol mono-n-butyl ether, and other low vapor pressure solvents.

The metal paste of the present embodiment may contain the high vapor pressure solvent and the low vapor pressure solvent from the viewpoint of achieving compatibility of printability and reducing volume shrinkage before and after firing the conductive via precursor (for example, between step c of forming the conductive via precursor and step d of firing the conductive via precursor) to minimize voids and cracks. In this case, each of the high vapor pressure solvent and the low vapor pressure solvent may be used alone or in combination of two or more kinds thereof. The content ratio of the high vapor pressure solvent to the low vapor pressure solvent may be 20/80 to 80/20 or may be 30/70 to 70/30, by mass ratio of [high vapor pressure solvent/low vapor pressure solvent].

A content of the volatile solvent in the metal paste of the present embodiment may be 2% by mass or more, 3% by mass or more, or 3.5% by mass or more, may be 5% by mass or less, 4.8% by mass or less, 4.5% by mass or less, 4.3% by mass or less, or 4% by mass or less, and may be 2 to 5% by mass, 3 to 4.8% by mass, or 3.5 to 4.5% by mass, based on the total mass of the metal paste.

The metal paste of the present embodiment may contain a resin component such as an epoxy resin. The metal paste of the present embodiment may have a content of the resin component of 10% by mass or less, 5% by mass or less, or may not contain a resin component.

The metal paste can be prepared by mixing metal particles such as the above-described copper particles and any components (such as additives) with the above-described volatile solvent. After mixing the components, a stirring treatment may be performed. In a dispersion, the maximum diameter may be adjusted by a classification operation. In addition, means such as three rolls, a kneader, and a planetary mixer can be used for mixing each component.

In a case where the metal paste contains the above-described first copper particles and second particles, the second copper particles, the surface treatment agent, and the dispersion medium are mixed in advance, and a dispersion treatment is performed to prepare a dispersion of the second copper particles, and the first copper particles, the other metal particles as necessary, and any additives may be further mixed to complete the preparation. According to such a procedure, the dispersibility of the second copper particles is improved, the mixability with the first copper particles is improved, and the performance of the metal paste is further improved. The dispersion of the second copper particles may be subjected to a classification operation to remove an aggregation substance.

The metal paste of the present embodiment may have a viscosity of 100 to 600 Pa·s, or 150 to 400 Pa·s at 25°C from the viewpoint of printability. The viscosity of the metal paste is measured by using a micro spiral viscometer PCU-02V (manufactured by Malcom Co., Ltd., product name) under conditions of a rotation speed of 10 rpm and a temperature of 25°C.

In the metal paste of the present embodiment, a Young's modulus of the sintered body measured by the following method may be 15 to 75 GPa, 20 to 60 GPa, or 25 to 50 GPa. In this case, cracks are less likely to occur in the peripheral portion of the through glass via formed on the glass substrate.

### [Measurement of Young's Modulus]

The metal paste was applied onto a glass substrate so that the size after drying was 40 mm × 10 mm × 0.22 mm. Next, the coating of the metal paste was fired according to the following procedure.
(a) The glass substrate provided with the coating of the metal paste was placed in a tube furnace (manufactured by AVC Co., LTD.), and argon gas was flowed at 1 L/min to replace air in the tube furnace with argon gas.
(b) Next, the temperature was increased to 300°C for 10 minutes while hydrogen gas was flowed at 300 mL/min, and a sintering treatment was performed at 300°C for 60 minutes.
(c) Thereafter, argon gas was flowed at a flow rate of 0.3 L/min and cooled, and the glass substrate on which the sintered body was formed was taken out into the air at 50°C or lower.
(d) A Young's modulus of the obtained sintered body is measured by a resonance method using JE2-RT model manufactured by Nihon Techno-Plus Co., Ltd. under conditions of a temperature of 23°C and a resonance frequency of 278.4 Hz.

In the metal paste of the present embodiment, for example, the Young's modulus of the sintered body tends to decrease when the firing temperature is lowered to reduce the degree of sintering of the metal particles, or the porosity is increased by blending or combination of the metal particles, and the Young's modulus of the sintered body tends to increase when the firing temperature is raised to increase the degree of sintering of the metal particles, or the porosity is lowered by blending or combination of the metal particles; thus, the Young's modulus of the sintered body can be set to the above-described range by appropriately setting the firing temperature or the blending composition of the metal particles.

### <Method for Manufacturing Conductive Via-Containing Glass Substrate>

A method for manufacturing a conductive via-containing glass substrate of the present embodiment includes: a step a of preparing a glass substrate provided with a hole and providing a metal paste part containing metal particles and a volatile solvent to fill the inside of the hole and cover at least a surface surrounding the hole of the glass substrate; a step b of heating the metal paste part to remove a part of the volatile solvent; a step c of removing a part of the metal paste part after heating to expose the surface to form a conductive via precursor in the hole, the conductive via precursor containing the metal particles and a residue of the volatile solvent and having a planarized exposed surface; and a step d of firing the conductive via precursor to form a conductive via, in which the metal particles include first metal particles having a volume average particle diameter of 0.8 µm or more and second metal particles having a volume average particle diameter of 0.5 µm or less, a metal particle concentration of the metal paste part provided in the step a is 95.0% by mass or more, and a content of the second metal particles in the metal paste part provided in the step a is 50% by mass or less based on a total amount of the metal particles.

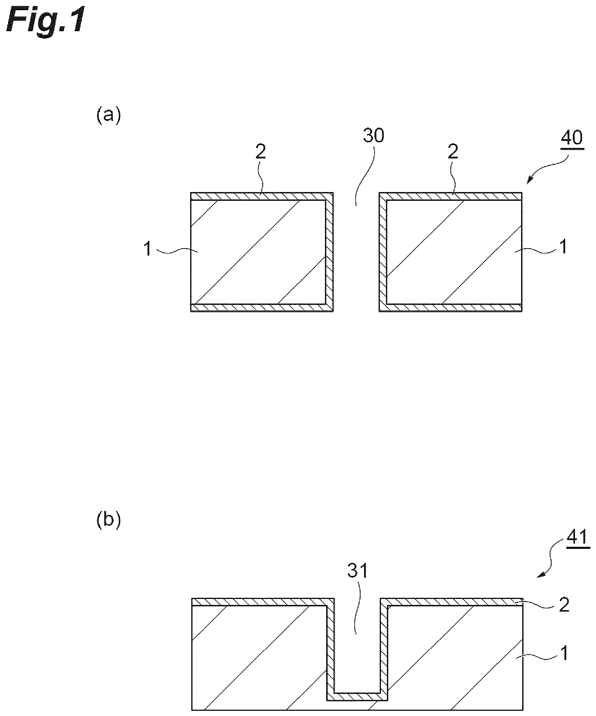

FIGS. 1 to 3 are schematic views illustrating an example of the method for manufacturing a conductive via-containing glass substrate according to the present embodiment. FIG. 1 illustrates an example of a glass substrate used in a method for manufacturing a conductive via-containing glass substrate. Hereinafter, the method for manufacturing a conductive via-containing glass substrate according to the present embodiment will be described with reference to these drawings. In the present embodiment, since the case where the metal paste contains the above-described copper particles as metal particles is exemplified, the copper particles, the copper layer, and the copper sintered body can be read as metal particles, a metal layer, and a metal sintered body, respectively.

[Step a] Examples of the material of the glass substrate provided with the hole prepared in this step include alkali-free glass, borosilicate glass, and quartz glass. The material of the glass substrate may be borosilicate glass or alkali-free glass from the viewpoint of suppressing the occurrence of cracks in the peripheral portion of the conductive via and further improving the connection reliability of the wiring board.

The hole may be a through-hole or a blind-hole. In the present embodiment, for example, as illustrated in (a) of FIG. 1, it is possible to prepare a glass substrate 40 including a glass base material 1 provided with a through-hole 30 and a metal coating 2 provided on a wall surface of the through-hole and surfaces of the glass substrate 1. The through-hole 30 penetrates through both main surfaces of the glass substrate 40. A case where a conductive via is provided in the glass substrate 40 will be described as an example.

The thickness of the glass base material 1 may be 100 µm or more, 200 µm or more, or 300 µm or more from the viewpoint of minimizing warpage of a substrate after sintering, and may be 800 µm or less, 300 µm or less, 200 µm or less, or 100 µm or less from the viewpoint of weight reduction and high density of a substrate.

An average linear thermal expansion coefficient a of the glass base material 1 may be 0.3 × 10⁻⁶ to 10 × 10⁻⁶ K⁻¹ or 2 × 10⁻⁶ to 8 × 10⁻⁶ K⁻¹.

An upper limit value of the hole diameter of the through-hole 30 may be 200 µm or less, 100 µm or less, or 60 µm or less from the viewpoint of achieving a high density of a semiconductor device to be obtained, and the lower limit value of the hole diameter of the through-hole 30 is not particularly limited, but may be 20 µm or more, 30 µm or more, or 50 µm or more.

The number of through-holes 30 provided in the glass substrate 40 may be 100 or more, 200 or more, or 300 or more per 1 cm² of the main surface of the substrate from the viewpoint of achieving a high density of a semiconductor device to be obtained.

The metal coating 2 may be provided on both main surfaces of the glass base material 1 and the wall surface of the through-hole 30, may be provided on at least one main surface of the glass base material 1 and the wall surface of the through-hole 30, may be provided on the wall surface of the through-hole 30 alone, or may not be provided. In the embodiment illustrated in (a) of FIG. 1, the glass substrate 40 is provided with the metal coating 2 on both main surfaces of the glass base material 1 and the wall surface of the through-hole 30. A primer layer such as an epoxy resin may be formed on both principal surfaces of the glass base material 1 and the wall surface of the through-hole 30, and the metal coating 2 may be provided on the surface of the primer layer.

Examples of the metal coating 2 include titanium, nickel, chromium, copper, aluminum, palladium, platinum, gold, and other metal material. From the viewpoint of adhesion, the metal coating 2 is preferably a coating with titanium, nickel, and copper layered in this order. The surface of the glass base material 1 is oxidized to form silicon oxide, and a titanium layer is formed on the silicon oxide, thereby improving adhesiveness. In addition, a nickel layer is provided on the titanium layer, and a copper layer is provided thereon to reduce diffusion of copper into the glass base material 1 as compared to a case where the copper layer is directly provided on the titanium layer. Furthermore, the copper layer is provided on the surface to improve the adhesion between the copper layer and the copper particles in the metal paste, resulting in the improvement on the reliability.

As illustrated in (b) of FIG. 1, in a case of preparing a glass substrate 41 provided with a blind-hole 31 as a hole, a conductive via serving as a through electrode can be formed by grinding a surface of the glass substrate opposite to the surface to which the blind-hole 31 is opened, after a step a, step b, step c, or step d. Examples of the grinding method include mechanical polishing, chemical mechanical polishing, and other grinding methods.

The metal paste part 3 can be provided by, for example, a method for directly applying a metal paste containing metal particles and a volatile solvent onto the glass substrate 40, or a method for preparing a film coated with a metal paste in advance and pressing the film against the substrate. In the former method, examples of the method for applying or filling the metal paste include printing methods such as a screen printing method, an inkjet printing method, an intaglio printing method, a lithographic printing method, an offset printing method, and a flexographic printing method, printing methods combining these printing methods, and methods such as a spin coating method, a dip method, a roll method, a squeegee method, and a press method. Among these methods, a screen printing method or a squeegee method in which a substrate is directly filled in a vacuum atmosphere, and a vacuum press method in which a film coated with a metal paste in advance is pressed in a vacuum atmosphere are preferable.

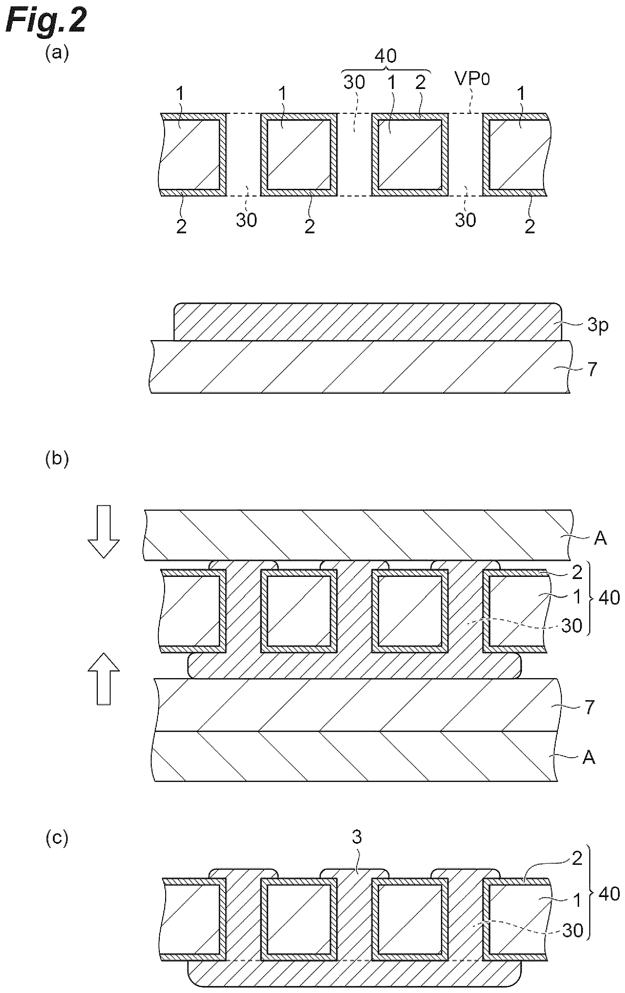

In the latter method, as illustrated in (a) to (c) of FIG. 2, the metal paste part 3 can be provided, for example, by producing a metal particle film in which a metal particle-containing layer 3p made of the above-described metal paste of the present embodiment is provided on a support film 7, and pressing the metal particle film against the substrate.

Examples of the support film 7 include a polyimide film, a polyethylene naphthalate film, a polyethylene terephthalate film, and other support films. The thickness of the support film may be 20 to 200 µm, 25 to 175 µm, or 30 to 150 µm from the viewpoint of workability for forming the metal particle-containing layer by coating.

The compositions of metal particles and a volatile solvent in the metal particle-containing layer can be appropriately set such that the conditions in the metal paste of the present embodiment described above are satisfied. The thickness of the metal particle-containing layer may be 100 µm or less. From the viewpoint of easily ensuring sufficient filling property of through-holes or blind-holes, the thickness of the metal particle-containing layer may be 30 µm or more, 40 µm or more, or 50 µm or more.

From the viewpoint of minimizing the occurrence of voids in the through-holes or the blind-holes, the metal particle-containing layer may have an undulation (height difference) of 20 µm or less or 10 µm or less on the surface opposite to the support film. As the undulation (height difference) is reduced, it is easy to fill a large number of through-holes or blind-holes present in the base all at once when the metal particle film is pressed to fill the holes of the base with a metal particle composition, and it is easy to reduce completely unfilled through-holes or blind-holes and through-holes or blind-holes in which voids partially occur. The evaluation of the undulation (height difference) can be measured by a non-contact method using a laser displacement meter or other instruments.

The metal particle film described above can be produced by applying the metal paste of the present embodiment described above on a support film to form a metal particle-containing layer having a concentration of metal particles of 95.0% by mass or more, or applying a metal paste having an increased content of a volatile solvent (for example, the concentration of the metal particles is increased to an amount of less than 94.0% by mass), and drying a coating film to form a metal particle-containing layer having a concentration of metal particles of 95.0% by mass or more.

Examples of the method for applying the metal paste include application methods by using screen printing, transfer printing, offset printing, a jet printing method, a dispenser, a jet dispenser, a needle dispenser, a comma coater, a slit coater, a die coater, a gravure coater, slit coating, relief printing, intaglio printing, gravure printing, stencil printing, soft lithography, bar coating, an applicator, a particle deposition method, a spray coater, a spin coater, a dip coater, or other application methods.

From the viewpoint of coating workability and uniformity of the thickness of the coating film, the metal paste can be applied onto the support film by screen printing.

The thickness of the coating film may be 1 µm or more, 2 µm or more, 3 µm or more, 5 µm or more, 10 µm or more, 15 µm or more, or 20 µm or more, and may be 300 µm or less, 250 µm or less, 200 µm or less, 150 µm or less, 120 µm or less, 100 µm or less, 80 µm or less, or 50 µm or less.

The step of drying the coating film to form the metal particle-containing layer can be performed at normal temperature or a temperature of normal temperature to 100°C or lower, and the atmosphere may be in the ambient atmosphere or in the nitrogen.

In the step a, the above-described metal particle film is pressed against the glass substrate 40 so that the metal particle-containing layer 3p of the metal particle film is brought into contact with the glass substrate 40 to fill the through-hole 30 of the glass substrate 40 with the metal paste. In this case, for example, as illustrated in (b) of FIG. 2, the metal particle film and the glass substrate 40 can be sandwiched and pressurized by a pressure jig A from above and below. The pressure jig A is not particularly limited, but may be a commercially available one, and may be manufactured by using a metal member with a flat part. For example, a pressure jig including two or more metal members can press the metal particle film against the glass substrate by sandwiching the metal particle film and the glass substrate between the metal members arranged such that the flat parts face each other. The pressure jig A may have a mechanism that adjusts the pressure applied to the metal particle film and the glass substrate. As the pressure adjusting means, a spring or other means can be used. In the present embodiment, a vacuum press method in which pressing is performed in a vacuum atmosphere may be used.

The press can be performed under the condition of, for example, a temperature of normal temperature to 50°C or lower, and may be performed under the condition of the atmosphere in the vacuum, in the ambient atmosphere, or in the nitrogen. For the purpose of reducing voids, the metal particle film may be pressed against the glass substrate after being held at a degree of vacuum of 1000 Pa or less or a degree of vacuum of 200 Pa or less. The pressure of the pressure jig when pressing the metal particle film against the glass base material may be a pressure within a range in which the glass substrate is not cracked, and may be, for example, 0.01 MPa or more, 0.1 MPa or more, or 1 MPa or more.

The metal paste part 3 may be sufficient to fill the inside of the hole and only cover at least the surface surrounding the hole of the substrate, but as illustrated in (b) and (c) of FIG. 2, the metal paste part may be pressed out from an opening portion (VP₀ in (a) of FIG. 2) of the through-hole, the opening portion being positioned opposite to the side where the metal particle film of the substrate is pressed, to cover the surface around the hole.

### [Step b]

In this step, the metal paste part is heated to remove a part of the volatile solvent. In other words, the metal paste part is heated so that a part of the volatile solvent remains. In a case where the above-described metal particle film is used, the metal paste part can be heated after the support film is peeled off.

The heating can be performed, for example, by using a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, a steam heating furnace, a hot plate press device, or other means.

The atmosphere for heating may be the ambient atmosphere, may be an oxygen-free atmosphere such as nitrogen and a rare gas, or may be a reducing atmosphere such as hydrogen and formic acid. For the ambient atmosphere, in a case where the heating temperature is higher than 100°C, the copper particles are easily oxidized, but in a case where the metal paste part contains the above-described high vapor pressure solvent as a volatile solvent, a part of the volatile solvent can be removed at a temperature of lower than 100°C, 95°C or lower, or 90°C or lower. In a case where the metal paste part does not contain the high vapor pressure solvent as a volatile solvent, for example, contains the above-described low vapor pressure solvent alone, the oxidation of the copper particles can be suppressed while a part of the volatile solvent is removed by heating at 110°C or higher, 130°C or higher, or 150°C or higher in an oxygen-free atmosphere or a reducing atmosphere.

In a case where the metal paste part contains the high vapor pressure solvent, the heating temperature may be 70°C or higher and lower than 100°C or may be 80°C or higher and 95°C or lower from the viewpoint of inhibiting the oxidation of the copper particles, and the heating time may be 5 to 60 minutes or 10 to 30 minutes from the viewpoint of inhibiting the oxidation of the copper particles.

In addition, the heating may be performed so that the concentration of the metal particles in the metal paste part is 96% by mass or more, 97.5% by mass or more, or 98% by mass or more, from the viewpoint of reducing volume shrinkage before and after firing the conductive via precursor (for example, between step c of forming the conductive via precursor and step d of firing the conductive via precursor) to minimize voids and cracks.

### [Step c]

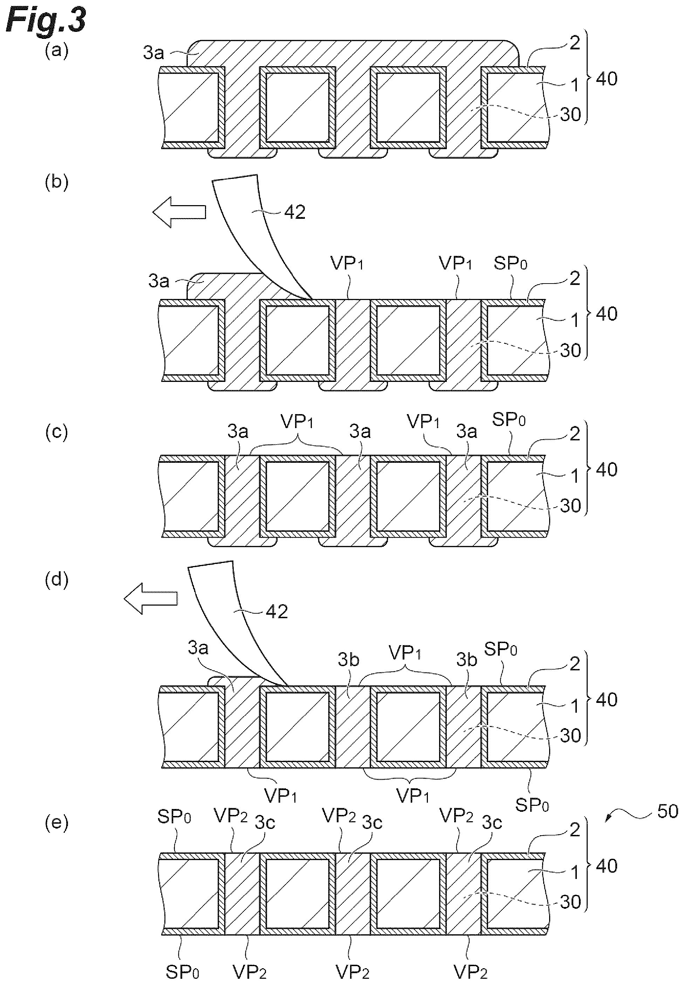

In this step, as illustrated in (a) to (d) of FIG. 3, the metal paste with which the holes are filled is planarized (or smoothed) while the metal paste that covers the surface of the substrate is removed with respect to the metal paste part 3a that is obtained after heating in step b. As a result, conductive via precursors 3b, each has a planarized exposed surface VP₁ and contains the metal particles and the residue of the volatile solvent, can be formed inside holes (through-holes 30) ((d) of FIG. 3).

The metal paste part can be removed, for example, by using a rubber squeegee 42 as illustrated in (b) and (d) of FIG. 3. As a result, a part of the metal paste part (the metal paste covering the surface of the substrate and the metal paste protruding from the holes) can be removed such that a surface SP₀ of the glass substrate 40 and the exposed surface VP₁ of the conductive via precursor 3b are leveled to form a planarized plane. In addition, as another method, removal with a metal squeegee such as SUS can be mentioned.

The step height between the surface SP₀ of the glass substrate 40 and the exposed surface VP₁ of the conductive via precursor 3b may be 5 µm or less or 3 µm or less in a direction perpendicular to the substrate surface. In addition, the average step height calculated by the following method may fall within the above-described range.

### (Average Step Height)

An average step height is calculated by acquiring an image of a cross-section passing through the center of a hole (via), binarizing the cross-section image to obtain a cross-sectional area Sa surrounded by inner walls of the hole (via), an exposed surface of a conductive via precursor, and an opening surface of the hole (via), and dividing the cross-sectional area Sa by a distance Wa between the inner walls of the hole.

### [Step d]

In this step, the conductive via precursor 3b formed in the step c is fired. As a result, a conductive via 3c including a metal body can be formed. The metal body can include a copper sintered body having a porous structure. A porosity of the conductive via may be 7% or less, 1.0 to 6.5%, or 1.5 to 5.0% from the viewpoint of suppressing penetration of a chemical solution into the copper sintered body and improving reliability when the conductive via is immersed in the chemical solution such as a resist stripping solution or a plating pretreatment in a subsequent step. When the conductive via is formed of a copper sintered body, the porosity of the copper sintered body may be in the above range. The porosity can be determined by the method described in Examples.

The firing can be performed by a heat treatment. The heat treatment can be performed, for example, by using heating means such as a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, and a steam heating furnace.

The atmosphere during the firing may be an oxygen-free atmosphere from the viewpoint of inhibiting the oxidation of the copper sintered body, or may be a reducing atmosphere from the viewpoint of removing the surface oxide of the copper particles in the conductive via precursor. Examples of the oxygen-free atmosphere include introduction of an oxygen-free gas such as nitrogen or a rare gas, or under a vacuum. Examples of the reducing atmosphere include pure hydrogen gas, a mixed gas of hydrogen and nitrogen represented by forming gas, nitrogen containing formic acid gas, a mixed gas of hydrogen and rare gas, and a rare gas containing formic acid gas. In a case where the conductive via precursor is sintered by heating without pressurization, the atmosphere may be pure hydrogen gas or a mixed gas of hydrogen and nitrogen represented by forming gas, and is preferably pure hydrogen gas. The heating in pure hydrogen gas can lead to a decrease in the sintering temperature of the copper particles. In a case where pure hydrogen gas is used, the gas reaches the central portion of the through-hole 30 even though the thickness of the substrate is as large as 600 µm, and the diameter of the through-hole 30 is as small as 10 µm. Thus, it is easy to obtain a metal body containing a copper sintered body.

The maximum attainable temperature during the heat treatment may be 150°C or higher, and may be 350°C or lower, 300°C or lower, or 260°C or lower from the viewpoint of reducing thermal damage to each member and improving the yield. As long as the maximum attainable temperature is 150°C or higher, sintering is likely to proceed sufficiently within a holding time of 60 minutes or less at the maximum attainable temperature. The holding time at the maximum attainable temperature may be 1 minute or more, and may be 60 minutes or less, 40 minutes or less, or 30 minutes or less from the viewpoint of volatilizing the entire volatile solvent and improving the yield.

In the present embodiment, as the metal paste of the present embodiment is used, sintering can be performed at a low temperature of 300°C or lower, 200°C or lower, or 150°C or lower in an atmosphere containing formic acid gas, and firing may be performed at 100 to 300°C, 100 to 200°C, or 100 to 150°C. Even in this case, a conductive via having excellent conductivity and connection reliability can be formed.

The firing of the conductive via precursor may be performed without pressurization, or may be performed with a pressure applied. In the latter case, under a pure hydrogen gas-containing atmosphere, the pressure may be 0.05 MPa or more, 0.1 MPa or more, or 0.3 MPa or more, and may be 20 MPa or less, 15 MPa or less, or 10 MPa or less. In addition, under a nitrogen gas-containing atmosphere, the pressure may be 1 MPa or more, or 3 MPa or more, and may be 20 MPa or less, 15 MPa or less, or 10 MPa or less.

By setting the pressure to 0.05 MPa or more when pure hydrogen gas is used, and to 1 MPa or more when nitrogen gas is used, the occurrence of voids in the conductive via formed in the central portion of the through-hole 30 is easily minimized, and a conductive via having good conductivity is easily obtained. In addition, in a case where the glass substrate 40 includes the metal coating 2, the bonding strength between the metal coating 2 and the conductive via is easily improved by setting the pressure to the above-described lower limit value or more.

In addition, in a case where the pressure applied during the firing is within the above-described range, a special pressurizing device is unnecessary. Thus, the minimization of voids, and a more improvement on the bonding strength and connection reliability can be achieved without impairing the yield. Examples of a method for applying pressure to the glass substrate including the conductive via precursor that is formed in the through-hole include a method for placing a weight, a method for applying pressure using a pressurizing device, and a method for applying pressure using a fixing jig for applying pressure.

The ratio of the copper element among the constituent elements, excluding the light element, in the copper sintered body contained in the metal body may be 95% by mass or more, 97% by mass or more, 98% by mass or more, or 100% by mass. In a case where the ratio of the copper element in the copper sintered body is within the above-described range, it is possible to reduce the formation of an intermetallic compound or the precipitation of foreign elements on the grain boundaries of metal copper crystal, the properties of the metal copper constituting the copper sintered body are easily enhanced, and a more excellent connection reliability is easily obtained.

In step d, since the conductive via precursor has the exposed surface VP₁ that is planarized and has a sufficiently small step height with respect to the substrate surface, and further has a composition that contributes to a reduced occurrence of volume shrinkage caused by firing, the step height between the surface SP₀ of the substrate 40 and an exposed surface VP₂ of the conductive via 3c can be sufficiently reduced.

The step height between the surface SP₀ of the glass substrate 40 and the exposed surface VP₂ of the conductive via precursor 3c (or a recess of the conductive via 3c) may be 5 µm or less or 3 µm or less in a direction perpendicular to the substrate surface. In addition, the average step height calculated by the following method may fall within the above-described range.

### (Average Step Height)

An average step height is calculated by acquiring an image of a cross-section passing through the center of a hole (via), binarizing the cross-section image to obtain a cross-sectional area Sb surrounded by inner walls of the hole (via), an exposed surface of a conductive via, and an opening surface of the hole (via), and dividing the cross-sectional area Sb by a distance Wb between the inner walls of the hole.

A conductive via-containing glass substrate 50 can be obtained through the above-described steps a to d. In the conductive via-containing glass substrate 50, since the exposed surface of the conductive via is planarized (or smoothed), and the step height with respect to the surface SP₀ of the glass substrate 40 is sufficiently small, it is possible to form a wiring easily, and to exhibit a sufficiently low connection resistance value even after the wiring is formed.

The method for manufacturing a conductive via-containing glass substrate according to the present embodiment can further include a step e of forming a wiring. This case can be used as a method for manufacturing a conductive via-containing wiring board.

### [Step e]

This step can include a resist forming step, a plating step, a resist removing step, and an etching step described below.

### <Resist Formation Step>

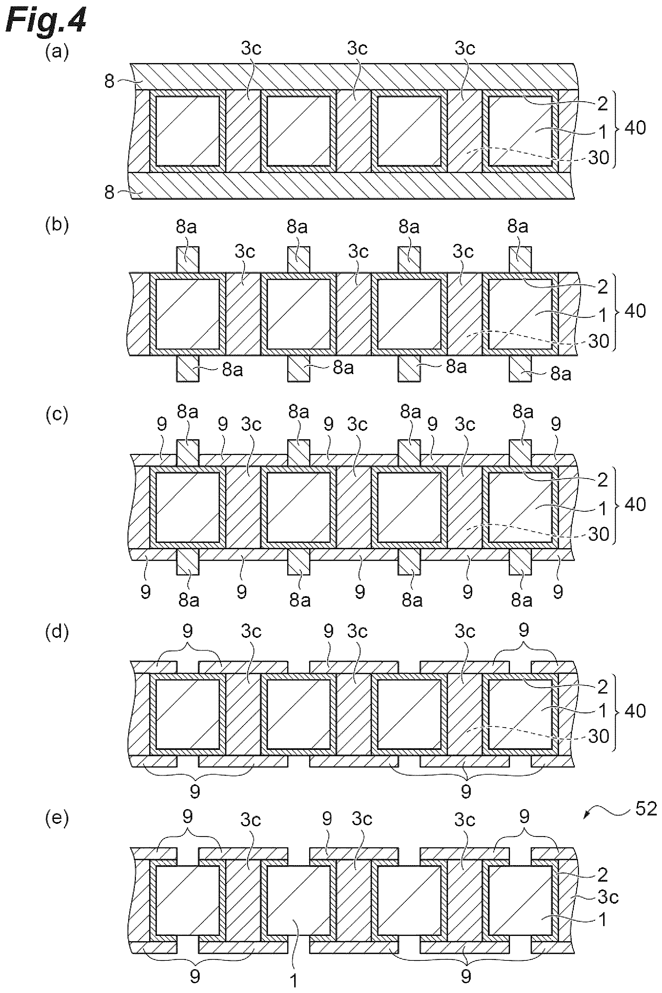

In the resist forming step, for example, as illustrated in (a) and (b) of FIG. 4, an etching resist 8a can be formed in the following manner: a negative photosensitive dry film 8 for an etching resist is laminated on the main surface of the glass substrate 40 and the conductive via 3c; a photomask that transmits light is then superimposed on a wiring shape; exposure is performed with ultraviolet rays; and unexposed portions are removed with a developer.

Examples of a method for forming the etching resist 8a other than the above-described manner include methods of silk-screen printing a resist ink and bonding a dry film resist with a laminator.

### <Plating Step>

In the plating step, for example, as illustrated in (c) of FIG. 4, a wiring 9 can be formed on opening portions of the etching resist 8a by a method such as electrolytic plating or electroless plating.

### <Resist Removing Step>

In the resist removing step, for example, as illustrated in (d) of FIG. 4, the etching resist 8a can be removed by a method such as peeling by a wet process using an alkaline aqueous solution or an organic solvent-based chemical solution such as an organic amine-based chemical solution such as TMAH or a ketone-based chemical solution such as acetone, or peeling by a dry process such as plasma or ozone.

### <Etching Step>

In the etching step, the metal coating 2 at a portion without coverage of the wiring 9 can be removed by etching. In the present embodiment, a part of the metal coating 2 provided on both main surfaces of the glass base material 1 is removed by etching.

Examples of the etching method include methods using a chemical etching solution used for a normal wiring board, such as a solution containing cupric chloride and hydrochloric acid, a ferric chloride solution, a solution containing sulfuric acid and hydrogen peroxide, or an ammonium persulfate solution.

A conductive via-containing wiring board 52 as illustrated in (e) of FIG. 4 can be obtained through the step e described above.

In the method described above, a step of removing at least a part of a conductor such as the sintered body of the metal paste or the metal coating 2, remaining on the main surface of the glass substrate 40, may be provided before the step e.

Examples of means for removing the conductor include chemical polishing, mechanical polishing, chemical mechanical polishing, fly cut treatment, plasma treatment, and other means. The fly cut process means cutting planarization by a surface planer.

In addition, a metal coating may be further formed on a surface of the conductive via-containing glass substrate 50 obtained through the above-described steps a to d. Examples of the metal coating include titanium, nickel, chromium, copper, aluminum, palladium, platinum, gold, and other metal material. From the viewpoint of adhesion or etching in a subsequent step, the metal coating is preferably copper. The metal coating can be formed by plating or sputtering, and is more preferably formed by sputtering. In this case, in the above-described resist forming step, plating step, resist removing step, and etching step, the oxidation of the metal sintered body can be suppressed by preventing the chemical solution from entering the metal sintered body having the porous structure, and the reliability can be improved.

According to the method for manufacturing a conductive via-containing glass substrate of the present embodiment, since it is possible to obtain a conductive via-containing substrate including a main surface (such as the metal coating 2, for example) that is sufficiently exposed, and having a conductive via that has a sufficiently small step height with respect to the main surface of the substrate, a step of planarizing the main surface of the substrate such as the step of removing the above-described conductor can be omitted.

In step e of the present embodiment, a resin layer forming step of forming a resin layer on the conductive via-containing wiring board may be further provided. As a result, it is possible to form a resin layer covering the wiring 9, it is possible to more effectively suppress the occurrence of cracks in the peripheral portion of the conductive via and deterioration of adhesion between glass and the wiring in the reliability test, and it is possible to further improve connection reliability of the wiring board.

Examples of the method for forming the resin layer include a method for applying a resin composition and a method for sticking a resin film. The resin composition and the resin film may be used as an interlayer insulating material. The resin layer may be cured by heating.

Further, in the present embodiment, a step S2 of providing a resin-containing portion containing a photosensitive resin composition or a cured product thereof in the conductive via of the conductive via-containing glass substrate obtained through the above-described steps a to d may be performed. This makes it easier to maintain excellent connection reliability even after the wiring formation. The present inventors infer the reason why such an effect is exhibited as follows. First, when the conductive via is formed by the metal sintered body having a porous structure, the stress relaxation property is obtained, and the effect of suppressing cracks of the material in the peripheral portion of the metal sintered body is easily obtained. On the other hand, the metal sintered body having a porous structure is likely to be adversely affected by oxidation (for example, oxidation of the metal sintered body accompanying permeation of the aqueous solution, and the like) due to permeation of a chemical or the like used at the time of wiring formation. On the other hand, it is considered that the above adverse effect can be sufficiently reduced by providing the resin-containing portion in the conductive via. In addition, the use of the photosensitive resin composition makes it possible to leave the resin composition in the metal sintered body while removing the resin composition on the surface of the metal sintered body by a corresponding development treatment, which is also considered to be one of the reasons for obtaining the above effect.

In addition, the resin-containing portion and a resin-free portion not containing the resin composition or the cured product thereof may be provided in the conductive via so that the resin-containing portion is unevenly distributed on an opening side (exposed surface side of the conductive via). As a result, it is possible to prevent an adverse effect caused by penetration of a chemical or the like in wiring formation in a subsequent step while suppressing an increase in the connection resistance value due to the resin-containing portion.

The photosensitive resin composition may be a negative type or a positive type as long as it can form a predetermined pattern by exposure and development.

Examples of the method for providing the conductive via with the resin-containing portion containing the photosensitive resin composition include a method for laminating a film-like photosensitive resin composition or applying a liquid photosensitive resin composition. When the conductive via is provided with the resin-containing portion containing the cured product of the photosensitive resin composition, the photosensitive resin composition can be cured after the resin-containing portion containing the photosensitive resin composition is provided. In this case, the photosensitive resin composition may contain a thermosetting component and may be thermosetting.

The step S2 may include a step S2-1a of impregnating at least a part of the conductive via with the negative photosensitive resin composition by laminating the film-like negative photosensitive resin composition on the surface of the conductive via-containing glass substrate, and a step S2-1a of removing the film-like negative photosensitive resin composition by a development treatment after the step S2-2a to expose the conductive via having the resin-containing portion containing the negative photosensitive resin composition at the opening of the hole.

As the film-like negative photosensitive resin composition, a dry film resist such as a photocurable dry film resist or a thermosetting dry film resist can be used, and for example, commercially available products such as RD-1619 (manufactured by Resonac Holdings Corporation, product name), HM-4035 (manufactured by Resonac Holdings Corporation, product name), HM-4056 (manufactured by Resonac Holdings Corporation, product name), TMMF NA1000 (manufactured by TOKYO OHKA KOGYO CO., LTD., product name), and PSR-800 AUS SR-1 (manufactured by Taiyo Ink Mfg. Co., Ltd., product name) may be used.

As a method for laminating the film-like negative photosensitive resin composition, a method such as a roll laminator, a laminator, or a press can be used.

A pressure may be 0.1 MPa or more, 0.4 MPa or more, or 1 MPa or more from the viewpoint of easily impregnating the conductive via with the photosensitive resin composition. An upper limit of the pressure may be 10 MPa or less from the viewpoint of reducing the influence on the substrate.

From the viewpoint of easily impregnating the conductive via with the photosensitive resin composition, the conductive via may be laminated while being heated. A heating temperature is not particularly limited as long as the photosensitive resin composition is not cured, and may be 50°C to 100°C or 70°C to 90°C.

From the viewpoint of easily impregnating the conductive via with the photosensitive resin composition, the negative photosensitive resin composition in the form of a film may be laminated after the degree of vacuum is maintained at 1000 Pa or less or 200 Pa or less.

A depth at which the conductive via is impregnated with the photosensitive resin composition may be 0.2% or more, 0.5% or more, or 1% or more with respect to the entire length of the conductive via in a thickness direction of the substrate from the viewpoint of connection reliability, and a distance from the exposed surface of the conductive via may be 1 µm or more, 2 µm or more, or 3 µm or more.

In the step S2-2a, a development treatment corresponding to the photosensitive resin composition can be performed. As the developer, for example, an alkaline aqueous solution obtained by dissolving an alkaline compound such as sodium carbonate, sodium hydroxide, potassium hydroxide, tetramethylammonium hydroxide, or choline in water so as to have a concentration of about 1 to 10% by mass, an alkaline aqueous solution such as ammonia water, or the like can be used. Examples of the developing method include a shower developing method, a spray developing method, an immersion developing method, and a paddle developing method.

The step S2 may further include a step S2-2a of curing the negative photosensitive resin composition contained in the resin-containing portion after the step S2-3a.

In the case of photocuring, as an actinic ray used for exposure, for example, a light ray using a g-ray stepper as a light source; an ultraviolet ray using a low-pressure mercury lamp, a high-pressure mercury lamp, a metal halide lamp, an i-line stepper, or the like as a light source; electron beam; a laser beam or the like can be used. The exposure amount is appropriately selected depending on the light source to be used, the thickness of the impregnated photosensitive resin composition, and the like.

When the negative photosensitive resin composition contains a thermosetting component, the negative photosensitive resin composition may be thermally cured.

The step S2 may further include a step S2-3a of performing a desmear treatment on at least the exposed surface of the conductive via after a step S2-4a.

Examples of the desmear treatment include plasma cleaning, and a treatment with a desmear solution containing permanganate and a caustic composition (for example, an alkali metal hydroxide or the like).

As another aspect, the step S2 may include a step S2-1b of impregnating at least a part of the conductive via with the negative photosensitive resin composition by applying a liquid negative photosensitive resin composition on the surface of the conductive via-containing substrate, and a step S2-2b of removing the coating of the liquid negative photosensitive resin composition by a development treatment after the step S2-1b to expose the conductive via having the resin-containing portion containing the negative photosensitive resin composition at the opening of the hole.

As the liquid negative photosensitive composition, for example, a commercially available product such as PSR-4000 G24K/CA-40 G24 (manufactured by Taiyo Ink Mfg. Co., Ltd., product name), TER-20HF (manufactured by Taiyo Ink Mfg. Co., Ltd., product name), or TMMR NA1000PM (manufactured by TOKYO OHKA KOGYO CO., LTD., product name) may be used.

Examples of the method for applying the liquid negative photosensitive composition include methods such as screen printing, transfer printing, offset printing, a jet printing method, a dispenser, a jet dispenser, a needle dispenser, a comma coater, a slit coater, a die coater, a gravure coater, slit coating, relief printing, intaglio printing, gravure printing, stencil printing, soft lithography, bar coating, an applicator, a particle deposition method, a spray coater, a spin coater, a dip coater, and other application methods. From the viewpoint of the workability of application and the uniformity of the thickness of the coating, the coating may be applied by screen printing or spin coating.

A depth at which the conductive via is impregnated with the photosensitive resin composition and a method for subjecting the coating of the liquid negative photosensitive resin composition to a development treatment may be the same as in the above-described steps S2-1a and S2-2a.

In addition, after the step S2-2b, a step S2-3b of curing the negative photosensitive resin composition contained in the resin-containing portion may be performed similarly to the above-described steps S2-3a and S2-4a, and after the step S2-3b, a step S2-4b of subjecting at least the exposed surface of the conductive via to a desmear treatment may be performed.

As another aspect, the step S2 may include a step S2-1c of impregnating at least a part of the conductive via with a positive photosensitive resin composition by applying a liquid positive photosensitive resin composition to the surface of the conductive via-containing glass substrate or laminating a film-like positive photosensitive resin composition, and a step S2-2c of removing the coating of the liquid positive photosensitive resin composition or the film-like positive photosensitive resin composition by an exposure and development treatment after the step S2-1c to expose the conductive via having the resin-containing portion containing the positive photosensitive resin composition at the opening of the hole.

As the positive photosensitive composition, for example, a commercially available product such as AH-3000 (manufactured by Resonac Holdings Corporation, product name), AR-5100 (manufactured by Resonac Holdings Corporation, product name), or OFPR-8600 (manufactured by TOKYO OHKA KOGYO CO., LTD., product name) may be used.

For the application of the photosensitive composition and the lamination of the photosensitive composition, the methods described above can be used.

The depth at which the conductive via is impregnated with the photosensitive resin composition may be the same as in the above-described step S2-1a.

The exposure in the step S2-2c is, for example, a light ray using a g-ray stepper as a light source; an ultraviolet ray using a low-pressure mercury lamp, a high-pressure mercury lamp, a metal halide lamp, an i-line stepper, or the like as a light source; electron beam; a laser beam or the like can be used. The exposure amount is appropriately selected depending on the light source to be used, the thickness of the impregnated photosensitive resin composition, and the like.

The coating of the liquid positive photosensitive resin composition and the method for subjecting the film-like positive photosensitive resin composition to a development treatment may be the same as in the above-described step S2-2a.

In addition, when the positive photosensitive resin composition contains a thermosetting component, the step S2-2c of thermally curing the positive photosensitive resin composition contained in the resin-containing portion may be performed after the step S2-3c. Further, after the step S2-3c, a step S2-4c of performing a desmear treatment on at least the exposed surface of the conductive via may be performed similarly to the above-described step S2-4a.

### Examples

Hereinafter, the present invention will be described in more details with reference to Examples and Comparative Examples, but the present invention is not limited to these Examples.

### [Preparation of Metal Paste]

### (Preparation Examples A to J and Comparative Preparation Example A)

Metal pastes were prepared by mixing the following raw materials in the proportions (parts by mass) shown in Tables 1 and 2, respectively, using three rolls.

### <First Copper Particles>

### (Wet Copper Powder)

Spherical copper particles W1: 1050Y (manufactured by MITSUI MINING & SMELTING CO., LTD., average particle diameter (D50): 0.81 µm, spherical shape)
Spherical copper particles W2: 1100Y (manufactured by MITSUI MINING & SMELTING CO., LTD., average particle diameter (D50): 1.1 µm, spherical shape)
Spherical copper particles W3: 1200Y (manufactured by MITSUI MINING & SMELTING CO., LTD., average particle diameter (D50): 2.1 µm, spherical shape)
Spherical copper particles W4: 1300Y (manufactured by MITSUI MINING & SMELTING CO., LTD., average particle diameter (D50): 3.5 µm, spherical shape)
Flat copper particles W1: 1100YP (manufactured by MITSUI MINING & SMELTING CO., LTD., average particle diameter (D50): 1.4 µm, flat)
Flat copper particles W2: 1200YP (manufactured by MITSUI MINING & SMELTING CO., LTD., average particle diameter (D50): 3.1 µm, flat)

### (Atomized Copper Powder)

Spherical copper particles A1: MA-C02K (manufactured by MITSUI MINING & SMELTING CO., LTD., average particle diameter (D50): 1.8 µm, spherical shape)
Spherical copper particles A2: MA-C025K (manufactured by MITSUI MINING & SMELTING CO., LTD., average particle diameter (D50): 2.4 µm, spherical shape)
Spherical copper particles A3: MA-C03K (manufactured by MITSUI MINING & SMELTING CO., LTD., average particle diameter (D50): 3.4 µm, spherical shape)

### <Second Copper Particles>

Spherical copper particles W5: CH0200L1 (manufactured by MITSUI MINING & SMELTING CO., LTD., average particle diameter (D50): 200 nm, spherical shape)

### <Resin Component>

Resin R1: "KFA -2000" (manufactured by Goo Chemical Co., Ltd., acrylic binder) as an organic binder, and a mixture of carbitol and terpineol as an organic solvent (a mass ratio of carbitol to terpineol in the mixture [carbitol:terpineol] = 1:1) were mixed in a mass ratio of 1:2

### <Volatile Solvent>

(High vapor pressure solvent: vapor pressure of 4 Pa or more and 30 Pa or less at 20°C)
α-Terpineol: manufactured by FUJIFILM Wako Pure Chemical Corporation, vapor pressure of 6.5 Pa at 20°C
(Low vapor pressure solvent: vapor pressure of less than 4 Pa at 20°C)
Diethylene glycol mono-n-butyl ether: manufactured by Showa Chemical Industry Co., Ltd., vapor pressure of 1.3 Pa at 20°C

For the metal pastes obtained in Preparation Examples A to J and Comparative Preparation Example A, the viscosity, printability, bondability, and volume resistivity of the sintered bodies were evaluated according to the following methods.

### <Viscosity>

The viscosity of the metal pastes was measured by using a micro spiral viscometer PCU-02V (manufactured by Malcom Co., Ltd., product name). The measurement conditions were a rotation speed of 10rpm and a temperature of 25°C.

### <Printability>

In <Production of Metal Particle Film> described later, when printing was performed on a PET film having a thickness of 100 µm by a screen printer, the number of pinhole portions where the coating was not applied on the PET film was measured. The printability was evaluated based on the number of pinhole portions according to the following criteria. Those evaluated as A to D can be determined to be good.

### (Criteria)

A: The number of pinhole portions is 0.
B: The number of pinhole portions is 1 or more and less than 3.
C: The number of pinhole portions is 3 or more and less than 5.
D: The number of pinhole portions is 5 or more and less than 10.
E: The number of pinhole portions is 10 or more and less than 20.
F: The number of pinhole portions is 20 or more.

In addition, in <Production of Metal Particle Film> described later, after the printing was performed on the PET film having a thickness of 100 µm by the screen printer, the coating amount (g) at a size of 8-inch φ was measured.

### <Bondability>

According to the following method, a bonding sample for a shear strength test was produced, and a die shear strength was measured to evaluate the bondability according to the following criteria. Those evaluated as A to C can be determined to be good.

### (Production of Bonding Sample for Shear Strength Test)

A metal paste was stencil-printed on a copper plate having a size of 25 × 20 × a thickness of 3 mm using a stainless steel mask having a square opening of 3 × 3 mm² and a thickness of 100 µm, and a squeegee. After drying at 90°C for 10 minutes with a hot plate, the resulting product was placed in a tube furnace (manufactured by AVC Co., LTD.), and argon gas was flowed at a flow rate of 1 L/min to replace air in the tube furnace with argon gas. Thereafter, the temperature was increased to 225°C for 10 minutes while hydrogen gas was flowed at 300 mL/min, and a sintering treatment was performed at 225°C for 60 minutes to sinter the metal paste. Thereafter, the resulting product was cooled while argon gas was flowed at a flow rate of 0.3 L/min and taken out into air at 50°C or lower to obtain a substrate containing a metal body formed on a copper plate as a bonding sample for the shear strength test.

### (Measurement of Die Shear Strength)

For the bonding sample for a shear strength test, the die shear strength was measured with a universal bond tester (4000 series, manufactured by Dage Japan Co., Ltd.) equipped with a DS-100 load cell by pressing the metal body or the Cu plate in the horizontal direction under the measurement conditions of a measurement speed of 5 mm/min and a measurement height of 50 µm. The mean value of 10 points was calculated and used as the mean value of the bonding strength.

### (Criteria)

A: Mean value of bonding strength is 50 N or more.
B: Mean value of bonding strength is 40 N or more and less than 50 N.
C: Mean value of bonding strength is 20 N or more and less than 40 N.
D: Mean value of bonding strength is 10 N or more and less than 20 N.
E: Mean value of bonding strength is less than 10 N.

### <Measurement of Volume Resistivity>

The metal paste prepared as described above was applied onto a glass wafer having a thickness of 1 mm by using an automatic film applicator (manufactured by Allgood Corporation), such that the application thickness was about 150 µm. The coating area was about 5 cm × about 10 cm. After the wafer provided with the coating film was dried at 90°C for 10 minutes with a hot plate, the resulting wafer was placed in a tube furnace (manufactured by AVC Co., LTD.), and argon gas was flowed at a flow rate of 1 L/min to replace air in the tube furnace with argon gas. Thereafter, the temperature was increased to 225°C for 10 minutes while hydrogen gas was flowed at 300 mL/min, and a sintering treatment was performed at 225°C for 60 minutes to sinter the metal paste. Thereafter, the resulting wafer was cooled while argon gas was flowed at a flow rate of 0.3 L/min and taken out into air at 50°C or lower to obtain a sample with a metal body formed on the wafer.

The volume resistivity of the metal body in the above-described sample was calculated from the surface resistance value measured with a four-point probe resistivity meter (Loresta GP, manufactured by Mitsubishi Chemical Analytech Co., Ltd.) and the film thickness obtained with a non-contact surface/layer cross-sectional shape measurement system (VertScan, Ryoka Systems Inc.).

**[Table 1]**

| | | | | | Preparation Example A | Preparation Example B | Preparation Example C | Preparation Example D | Preparation Example E | Preparation Example F |
|---|---|---|---|---|---|---|---|---|---|---|
| Composition | Copper particle | First copper particle | Wet copper powder | Spherical copper particle W1 | 30 | - | - | - | - | - |
| | | | | Spherical copper particle W2 | - | 30 | - | - | - | - |
| | | | | Spherical copper particle W3 | - | - | 30 | - | - | - |
| | | | | Spherical copper particle W4 | - | - | - | 30 | - | - |
| | | | | Flat copper particle W1 | - | - | - | - | 30 | - |
| | | | | Flat copper particle W2 | - | - | - | - | - | 30 |
| | | | Atomized copper powder | Spherical copper particle A1 | 30 | - | | - | - | - |
| | | | | Spherical copper particle A2 | - | 30 | 30 | - | 30 | 30 |
| | | | | Spherical copper particle A3 | - | - | - | 30 | - | - |
| | | Second copper particle | Wet copper powder | Spherical copper particle W5 | 30 | 30 | 30 | 30 | 30 | 30 |
| | Volatile solvent | High vapor pressure solvent | α-Terpineol (6.5 Pa) | | 2 | 2 | 2 | 2 | 2 | 2 |
| | | Low vapor pressure solvent | Diethylene glycol mono-n-butyl ether | | 2 | 2 | 2 | 2 | 2 | 2 |
| Content of metal particles in metal paste (% by mass) | | | | | 95.7 | 95.7 | 95.7 | 95.7 | 95.7 | 95.7 |
| Properties | Viscosity (Pa·s@25°C) | | | | 200 | 190 | 180 | 170 | 350 | 320 |
| | Printabilit y | Determination | | | A | A | A | A | A | A |
| | | Coating amount (g) | | | 4.7 | 4.7 | 4.6 | 4.4 | 6.3 | 5.9 |
| | Bondabilit y | Bonding strength with Cu (N) | | | 67 | 65 | 58 | 64 | 72 | 68 |
| | | Determination | | | A | A | A | A | A | A |
| | Volume resistivity (µΩ·cm) | | | | 3.5 | 3.7 | 4 | 4 | 4.2 | 4.2 |

**[Table 2]**

| | | | | | Preparation Example G | Preparation Example H | Preparation Example I | Preparation Example J | Comparative Preparation Example A |
|---|---|---|---|---|---|---|---|---|---|
| Composition | Copper particle | First copper particle | Wet copperpowder | Spherical copper particle W1 | 20 | - | - | - | 30 |
| | | | | Spherical copper particle W2 | - | - | 20 | - | - |
| | | | | Spherical copper particle W3 | 20 | - | - | - | - |
| | | | | Spherical copper particle W4 | 20 | - | - | 20 | - |
| | | | | Flat copper particle W1 | - | - | 20 | - | - |
| | | | | Flat copper particle W2 | - | - | - | 20 | - |
| | | | Atomized copper powder | Spherical copper particle A1 | - | 20 | - | - | - |
| | | | | Spherical copper particle A2 | - | 20 | 20 | 20 | 30 |
| | | | | Spherical copper particle A3 | - | 20 | - | - | - |
| | | Second copper particle | Wet copper powder | Spherical copper particle W5 | 30 | 30 | 30 | 30 | 30 |
| | Resin component | Resin R1 | | | - | - | - | - | 5*¹ |
| | Volatile solvent | High vapor pressure solvent | α-Terpineol (6.5 Pa) | | 2 | 2 | 2 | 2 | 2 |
| | | Low vapor pressure solvent | Diethylene glycol mono-n-butyl ether | | 2 | 2 | 2 | 2 | 2 |
| Content of metal particles in metal paste (% by mass) | | | | | 95.7 | 95.7 | 95.7 | 95.7 | 94.7 |
| Properties | Viscosity (Pa·s@25°C) | | | | 450 | 210 | 250 | 230 | 450 |
| | Printability | Determination | | | C | A | A | A | C |
| | | Coating amount (g) | | | 7 | 4.4 | 6.2 | 5.5 | 8.2 |
| | Bondability | Bonding strength with Cu (N) | | | 65 | 30 | 70 | 70 | 34 |
| | | Determination | | | A | C | A | A | C |
| | Volume resistivity (µΩ·cm) | | | | 3.1 | 4.5 | 3.8 | 3.8 | 30.5 |

| | | | | | | | | | |
|---|---|---|---|---|---|---|---|---|---|
| *1: 2/3 of 5 parts by mass is an organic solvent. | | | | | | | | | |

### [Production of Conductive Via-Containing Glass Substrate]

### (Examples 1 to 13 and Comparative Examples 1 to 4)

A conductive via-containing glass substrate was produced by the following procedure.

### <Preparation of Glass Substrate>

Glass substrate A: A glass substrate "D263Teco" (manufactured by SCHOTT AG, trade name, material: borosilicate glass, average linear thermal expansion coefficient α: 7.2 × 10⁻⁶ K⁻¹) including a through-hole and having a titanium layer (thickness 100 nm) and a copper layer (thickness 300 nm) formed in this order on both principal surfaces and on a wall surface of the through-hole was prepared. The glass substrate has a diameter of 6 inches and a thickness of 300 µm, the titanium layer and the copper layer are sequentially formed by sputtering, and a through-hole having a hole diameter (via diameter) of 90 µm is provided.

Glass substrate B: A glass substrate "OA-10G" (manufactured by Nippon Electric Glass Co., Ltd., trade name, material: alkali-free glass, average linear thermal expansion coefficient α: 3.8 × 10⁻⁶ K⁻¹) including a through-hole and having a titanium layer (thickness 100 nm) and a copper layer (thickness 300 nm) formed in this order on both principal surfaces and on a wall surface of the through-hole was prepared. The glass substrate has a diameter of 6 inches and a thickness of 300 µm, the titanium layer and the copper layer are sequentially formed by sputtering, and a through-hole having a hole diameter (via diameter) of 90 µm is provided.

### <Production of Metal Particle Film>

The metal paste prepared as described above was printed on a PET film having a thickness of 100 µm with a screen printer in a size of 8-inch φ (circular shape with a diameter of 20 cm) using a screen printing plate (wire diameter: 23 µm, the number of meshes: 400, mesh size: 41 µm, and space ratio: 41 µm) to obtain a metal particle film provided with a metal particle-containing layer.

### <Formation of Conductive Via>

The metal particle film was bonded to the glass substrate from the metal particle-containing layer side with a bonding device VJ-35 (manufactured by Ayumi Industry Co., Ltd.), and the resulting laminate was further vacuum-pressed at room temperature and a pressure of 3 MPa to fill the through-holes with the metal paste. At this time, the metal paste was protruded from one side of the glass substrate opposite to the other side of the glass substrate on which the metal particle film was bonded. In Examples 1 to 11 and Comparative Examples 1 and 2, the glass substrate A was used, and in Examples 12 and 13 and Comparative Examples 3 and 4, the glass substrate B was used.

Next, the PET film peeled off from the laminate was dried in the ambient atmosphere at 90°C for 10 minutes. The concentrations (% by mass) of the metal particles in the metal paste parts before and after drying are shown in the table.

For the dried laminate, as illustrated in (a) to (d) of FIG. 3, the metal paste on the main surface of the glass substrate on which the metal particle film was bonded was removed using a rubber squeegee, and subsequently, the metal paste protruding from one side of the glass substrate opposite to the other side of the glass substrate on which the metal particle film was bonded was removed using the rubber squeegee.

Next, the glass substrate having conductive via precursors formed in the through-holes by the above-described steps was placed in a tube furnace (manufactured by AVC Co., LTD.), and argon gas was flowed at a flow rate of 1 L/min to replace air in the tube furnace with argon gas. Thereafter, the temperature was increased to 300°C for 10 minutes while hydrogen gas was flowed at 300 mL/min, and a sintering treatment was performed at 300°C for 60 minutes to sinter the conductive via precursors. Thereafter, the resulting substrate was cooled while argon gas was flowed at a flow rate of 0.3 L/min and taken out into air at 50°C or lower to obtain a conductive via-containing glass substrate.

### <Evaluation of Conductive Via-Containing Glass Substrate>

For the conductive via-containing glass substrate obtained as described above, the presence or absence of cracks and voids in the conductive vias, the porosity of the conductive via, and the recess after sintering was evaluated according to the following method.

### (Presence or Absence of Cracks in Conductive Vias)

The cross-section of the conductive vias of the conductive via-containing glass substrate was exposed by cross-section polishing, and 30 conductive vias were observed with a digital microscope (VHX-6000, manufactured by KEYENCE CORPORATION) to confirm the presence or absence of cracks (a length of 10 µm or more).

### (Presence or Absence of Voids in Conductive Vias)

The cross-section of the conductive vias of the conductive via-containing glass substrate was exposed by cross-section polishing, and 30 conductive vias were observed with a digital microscope (VHX-6000, manufactured by KEYENCE CORPORATION) to confirm the presence or absence of voids (a diameter of 5 µm or more).

### (Recess after Sintering)

The cross-section of the conductive vias of the conductive via-containing glass substrate was exposed by cross-section polishing, and 30 conductive vias were observed with a digital microscope (VHX-6000, manufactured by KEYENCE CORPORATION) to calculate the average step height by the following method.

### [Average Step Height]

An average step height (= Sb/Wb) was calculated by acquiring an image of a cross-section passing through the center of a via, binarizing the cross-section image to obtain a cross-sectional area Sb surrounded by inner walls of the via, an exposed surface of a conductive via, and an opening surface of the via, and dividing the cross-sectional area Sb by a distance Wb between the inner walls of the hole.

The mean value of the average step heights at 30 points was calculated, and the recess after sintering was evaluated according to the following criteria. Those evaluated as A, B, and C can be determined to be good.

### (Criteria)

A: Mean value of average step heights is less than 1 µm.
B: Mean value of average step heights is 1 µm or more and less than 3 µm.
C: Mean value of average step heights is 3 µm or more and less than 5 µm.
D: Mean value of average step heights is 5 µm or more and less than 10 µm.
E: Mean value of average step heights is 10 µm or more.

### (Porosity of Conductive Via)

The conductive via-containing glass substrate subjected to the mechanical polishing treatment was cut in a thickness direction, a cross section of the central portion of the conductive via of the glass substrate was exposed by a focused ion beam, and the cross section was observed. When observing the cross section of the central portion of the through-hole of the glass substrate, a range of ±5 µm in the thickness direction of the glass substrate and a range of ±5 µm in the direction orthogonal to the thickness direction of the glass substrate were observed from the central portion of the through-hole. As the focused ion beam machining observation device, MI4050 (manufactured by Hitachi High-Technologies Corporation) was used. For the observation, a cross-section image (about 10 µm square) of the conductor was imaged using a scanning electron microscope S-3700N (manufactured by Hitachi High-Tech Corporation) at a magnification of 5000 times. The number of observation points was five. The obtained cross-sectional image was binarized using image analysis software (Adobe Photoshop (registered trademark) Elements) so that a sintered copper portion and a porous (pore) portion were separated. For each of the five observation points, a ratio of the area of the porous (pore) portion to the total area of the conductive via cross section was determined, and this was taken as a porosity. An average value of the porosities of the five observation points was taken as a porosity of the conductive via.

### [Preparation and Evaluation of Wiring Board]

### (Examples 1 to 13 and Comparative Examples 1 to 4)

A wiring was formed on the conductive via-containing glass substrate produced in the same manner as described above according to the following procedure to obtain a wiring board, and an evaluation thereof was performed.

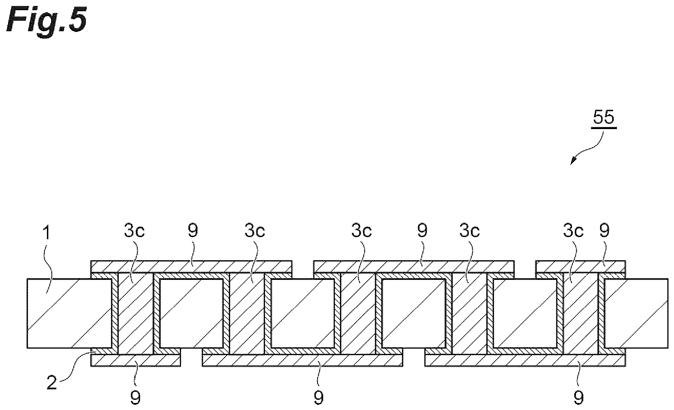

A dry film H-W425 (manufactured by Resonac Holdings Corporation, trade name) for an ultraviolet curable etching resist was pressure-bonded to the surface of the conductive via-containing glass substrate obtained as described above with a laminator. Thereafter, a photomask was aligned to expose a wiring pattern, and resist development was performed. Next, electrolytic plating was performed on opening portions of the resist, and peeling of the resist and etching of the seed layer were then performed to form a wiring having a wiring pattern of 300 µm × 600 µm, thereby obtaining a test piece 55 (wiring board) as illustrated in FIG. 5. The wiring pattern was finished so as to have a thickness of about 10 µm after etching of the seed layer. In the test piece 55, the conductive vias formed in the through-holes are electrically connected by the wiring provided on the substrate surface.

In addition, in Examples 11 and 13 and Comparative Examples 2 and 4, ABF film "ABF GX92" (manufactured by Ajinomoto Fine-Techno Co., Inc.) was bonded to both surfaces of the test piece 55 on which a wiring pattern was formed by hot pressing to prepare a resin layer-containing test piece. A thickness of the resin layer was about 30 µm.

For the test piece obtained as described above, the initial resistance value, the connection reliability, the presence or absence of cracking in the substrate, and the recesses of the conductive vias after resist peeling were evaluated according to the following methods.

### (Initial Resistance Value)

As an initial resistance value of the test piece 55 (or the resin layer-containing test piece), a resistance value in which 1000 vias of 90 µmφ were connected was measured. The initial resistance value was evaluated based on this interconnection resistance value according to the following criteria. Those evaluated as A and B can be determined to be good.

### (Number of Vias)

90 µmφ: 1000

### (Criteria)

A: Resistance value is less than 6 Ω.
B: Resistance value is 6 Ω or more and less than 10 Ω.
C: Resistance value is 10 Ω or more and less than 20 Ω.
D: Resistance value is 20 Ω or more and less than 50 Ω.
E: Resistance value is 50 Ω or more.

### (Connection Reliability)

The test piece 55 (or the resin layer-containing test piece) was set in a temperature cycle tester (TSA-72SE-W, manufactured by ESPEC CORP.), and a temperature cycle connection reliability test was performed under the conditions of low temperature side: -55°C, 15 minutes, room temperature: 2 minutes, high temperature side: 125°C, 15 minutes, defrosting cycle: automatic, and the number of cycles: 50, 100, 300, 500, and 1000 cycles. For the test piece after undergoing each of the number of cycles, a resistance value in which the vias of the number described above were connected was measured. The connection reliability was evaluated based on this interconnection resistance value according to the following criteria.

### (Criteria)

A: Resistance change rate is less than 1% with respect to initial resistance value.
B: Resistance change rate is 1% or more and less than 3% with respect to initial resistance value.
C: Resistance change rate is 3% or more and less than 5% with respect to initial resistance value.
D: Resistance change rate is 5% or more and less than 10% with respect to initial resistance value.
E: Resistance change rate is 10% or more and less than 20% with respect to initial resistance value.
F: Resistance change rate is 20% or more with respect to initial resistance value.
G: A conduction failure occurs.

### (Cracking of Substrate)

The test piece 55 (or the resin layer-containing test piece) was visually confirmed, and the presence or absence of cracks of the glass substrate was confirmed.

### (Recess after Resist Peeling)

As for the production of the test piece 55 (or the resin layer-containing test piece), after resist peeling, the cross-section of the conductive vias was exposed by cross-section polishing, and 30 conductive vias were observed with a digital microscope (VHX-6000, manufactured by KEYENCE CORPORATION) to calculate the mean value of the average step heights by the same method as for evaluating the recess after sintering. Then, the recess after resist peeling was evaluated according to the following criteria. Those evaluated as A, B, and C can be determined to be good.

### (Criteria)

A: Mean value of average step heights is less than 1 µm.
B: Mean value of average step heights is 1 µm or more and less than 3 µm.
C: Mean value of average step heights is 3 µm or more and less than 5 µm.
D: Mean value of average step heights is 5 µm or more and less than 10 µm.
E: Mean value of average step heights is 10 µm or more.

**[Table 3]**

| | | | Example 1 | Example 2 | Example 3 | Example 4 | Example 5 | Example 6 | Example 7 | Example 8 | Example 9 |
|---|---|---|---|---|---|---|---|---|---|---|---|
| Metal paste | | | Preparation Example A | Preparation Example B | Preparation Example C | Preparation Example D | Preparation Example E | Preparation Example F | Preparation Example G | Preparation Example H | Preparation Example I |
| Substrate | | Glass substrate | A | A | A | A | A | A | A | A | A |
| | | Material | Borosilicate | Borosilicate | Borosilicate | Borosilicate | Borosilicate | Borosilicate | Borosilicate | Borosilicate | Borosilicate |
| | | Type of hole | Through | Through | Through | Through | Through | Through | Through | Through | Through |
| | | Via diameter (µm) | 90 | 90 | 90 | 90 | 90 | 90 | 90 | 90 | 90 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removal method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ | 100% H₂ |
| Step e | | Resin layer | Absent | Absent | Absent | Absent | Absent | Absent | Absent | Absent | Absent |
| Concentration of metal particles in metal paste part (% by mass) | | Before drying (step a) | 95.7 | 95.7 | 95.7 | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absent | Absent | Absent | Absent | Absent | Absent | Absent | Absent | Absent |
| | Void | | Absent | Absent | Absent | Absent | Absent | Absent | Absent | Absent | Absent |
| | Recess after sintering | (µm) | 0.6 | 0.9 | 0.8 | 1.3 | 3.2 | 3.5 | 2.5 | 2.6 | 1.5 |
| | | Determination | A | A | A | B | C | C | B | B | B |
| | Recess after resist peeling | (µm) | 0.8 | 1.2 | 1.2 | 1.5 | 3.7 | 4.1 | 3.5 | 3.4 | 2.1 |
| | | Determination | A | B | B | B | C | C | C | C | B |
| | Porosity (%) | | 3 | 3 | 3 | 4 | 5 | 6 | 4 | 3 | 4 |
| Wiring board | Initial resistance value | | A | A | A | A | A | A | A | A | A |
| | After reliability test | 50 times | A | A | A | A | A | A | A | A | A |
| | | 100 times | A | A | A | A | A | A | A | A | A |
| | | 300 times | A | A | A | A | A | A | A | A | A |
| | | 500 times | B | B | B | B | B | B | B | B | B |
| | | 1000 times | B | B | B | B | B | B | B | B | B |
| | Cracking of substrate | | Absent | Absent | Absent | Absent | Absent | Absent | Absent | Absent | Absent |

**[Table 4]**

| | | | Example 10 | Example 11 | Example 12 | Example 13 | Comparative Example 1 | Comparative Example 2 | Comparative Example 3 | Comparative Example 4 |
|---|---|---|---|---|---|---|---|---|---|---|
| Metal paste | | | Preparation Example J | Preparation Example J | Preparation Example J | Preparation Example J | Comparative Preparation Example A | Comparative Preparation Example A | Comparative Preparation Example A | Comparative Preparation Example A |
| Substrate | | Glass substrate | A | A | B | B | A | A | B | B |
| | | Material | Borosilicate | Borosilicate | Alkali-free | Alkali-free | Borosilicate | Borosilicate | Alkali-free | Alkali-free |
| | | Type of hole | Through | Through | Through | Through | Through | Through | Through | Through |
| | | Via diameter (µm) | 90 | 90 | 90 | 90 | 90 | 90 | 90 | 90 |
| | | Via depth (µm) | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removal method | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ |
| Step e | | Resin layer | Absent | Present | Absent | Present | Absent | Present | Absent | Present |
| Concentration of metal particles in metal paste part (% by mass) | | Before drying (step a) | 95.7 | 95.7 | 95.7 | 95.7 | 94.7 | 94.7 | 94.7 | 94.7 |
| | | After drying (step b) | 97.8 | 97.8 | 97.8 | 97.8 | 96.0 | 96.0 | 96.0 | 96.0 |
| Conductive via | Crack | | Absent | Absent | Absent | Absent | Absent | Absent | Absent | Absent |
| | Void | | Absent | Absent | Absent | Absent | Absent | Absent | Absent | Absent |
| | Recess after sintering | (µm) | 1.7 | 1.7 | 1.7 | 1.7 | 1.7 | 1.7 | 1.7 | 1.7 |
| | | Determination | B | B | B | B | B | B | B | B |
| | Recess after resist peeling | (µm) | 2.5 | 2.5 | 2.5 | 2.5 | 2.5 | 2.5 | 2.5 | 2.5 |
| | | Determination | B | B | B | B | B | B | B | B |
| | Porosity (%) | | 4 | 4 | 4 | 4 | 8 | 8 | 8 | 8 |
| Wiring board | Initial resistance value | | A | A | A | A | E | E | E | E |
| | After reliability test | 50 times | A | A | A | A | A | A | A | A |
| | | 100 times | A | A | B | A | A | A | B | A |
| | | 300 times | A | A | B | A | A | A | B | A |
| | | 500 times | A | A | C | A | A | A | C | A |
| | | 1000 times | A | A | C | A | A | A | C | A |
| | Cracking of substrate | | Absent | Absent | Absent | Absent | Absent | Absent | Absent | Absent |

### [Observation and Consideration of Conductive Vias]

### (Observation 1)

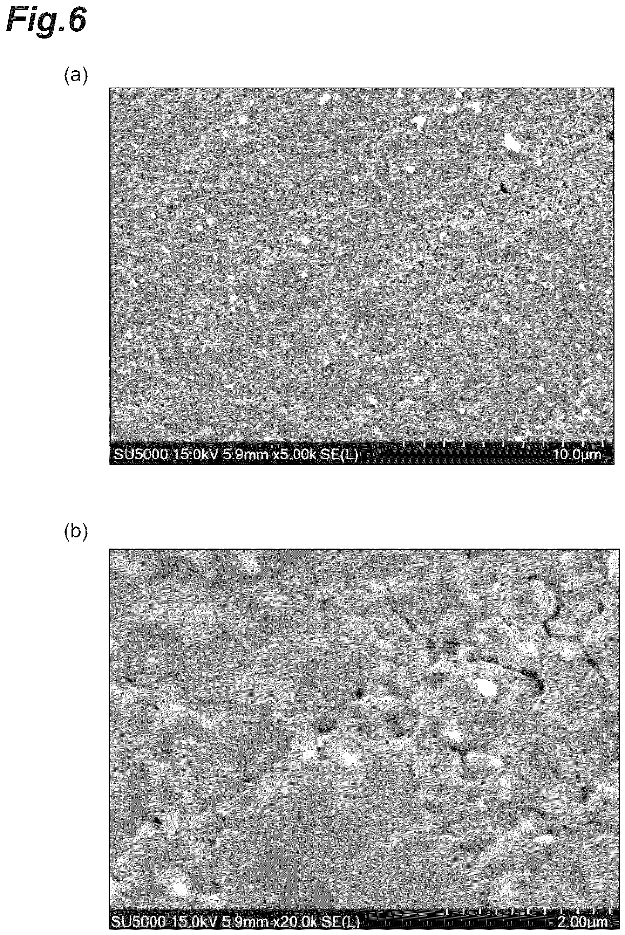

For the conductive via-containing glass substrate produced in Example 1, the cross-section of the central portion of the conductive via of the conductive via-containing glass substrate was exposed using a focused ion beam machining observation device (manufactured by Hitachi High-Tech Corporation, trade name: MI4050) by the focused ion beam, and the resulting cross-section was observed. For the observation, a cross-section image of the copper sintered body was imaged using a scanning electron microscope (manufactured by Hitachi High-Tech Corporation, trade name: S-3700N) at magnifications of 5000 times and 20000 times (see FIG. 6). In the image illustrated in FIG. 6, (a) is an image with a magnification of 5000 times, and (b) is an image with a magnification of 20000 times. As illustrated in (b) of FIG. 6, the copper sintered body has a structure in which the second copper particles are filled with the first copper particles and the particles are bonded to each other. It is considered that, by formation of such a dense copper sintered body, suppression of the occurrence of voids or cracks due to suppression of shrinkage during sintering, and suppression of recesses, a sufficiently low connection resistance value can be exhibited even after wiring formation, and the obtained wiring board can have excellent connection reliability.

### [Observation and Consideration of Wiring Board]

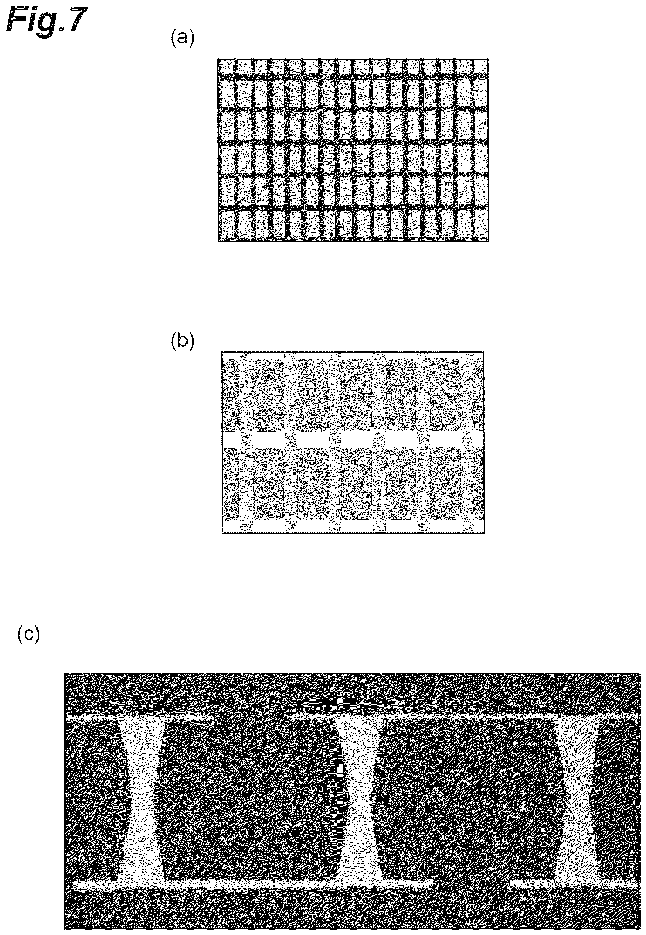

The appearance and the cross section of the wiring board produced in Example 1 were observed with an optical microscope. In the image illustrated in FIG. 7, (a) illustrates an appearance of the wiring board, (b) illustrates an enlarged view of a part of (a), and (c) illustrates a cross section of the wiring board. As illustrated in FIG. 7, the via portion of the glass substrate is filled with the copper sintered body without any void, and the copper wiring is preferably formed in the conductive via portion filled with the copper sintered body.

### [Production of Conductive Via-Containing Glass Substrate]

### (Comparative Examples 5 to 8)

A conductive via-containing glass substrate was produced by the following procedure.

### <Preparation of Glass Substrate>

A glass substrate A and a glass substrate B similar to those described above were prepared.

### <Formation of Conductive Via>

The glass substrate was immersed in a copper sulfate plating solution to perform electrolytic copper plating, thereby filling a via portion having a via diameter of 90 µm. Next, the deposited copper plating coatings on both surfaces of the glass substrate were polished using a CMP slurry to finish the glass substrate so that a thickness of copper on the glass substrate was about 1 µm.

**[Table 5]**

| | | | Comparative Example 5 | Comparative Example 6 | Comparative Example 7 | Comparative Example 8 |
|---|---|---|---|---|---|---|
| Substrate | | Glass substrate | A | A | B | B |
| | | Material | Borosilicate | Borosilicate | Alkali-free | Alkali-free |
| | | Type of hole | Through | Through | Through | Through |
| | | Via diameter (µm) | 90 | 90 | 90 | 90 |
| | | Via depth (µm) | 300 | 300 | 300 | 300 |
| Step e | | Resin layer | Absent | Present | Absent | Present |
| Conductive via | Crack | | Absent | Absent | Absent | Absent |
| | Void | | Absent | Absent | Absent | Absent |
| Wiring board | Initial resistance value | | A | A | A | A |
| | After reliability test | 50 times | A | A | D | A |
| | | 100 times | A | A | G | A |
| | | 300 times | D | A | G | A |
| | | 500 times | G | D | G | E |
| | | 1000 times | G | G | G | G |
| | Cracking of substrate | | Absent | Absent | Present | Absent |

### [Observation and Consideration of Wiring Board after Temperature Cycle Test]

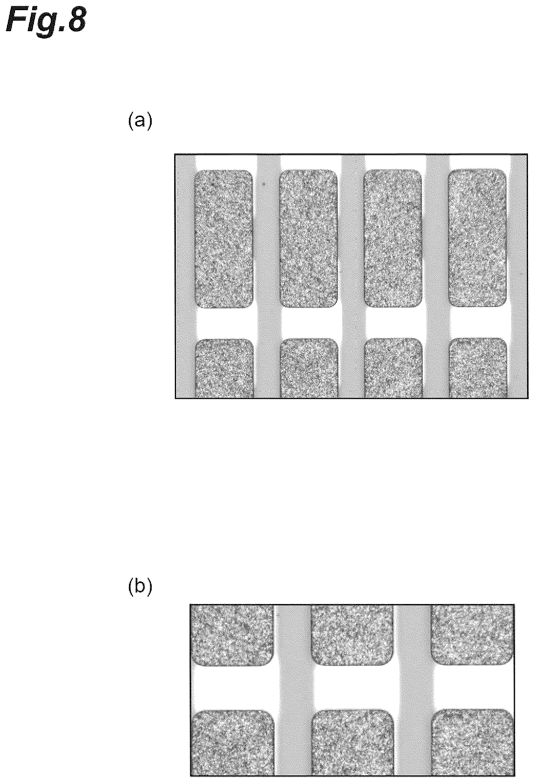

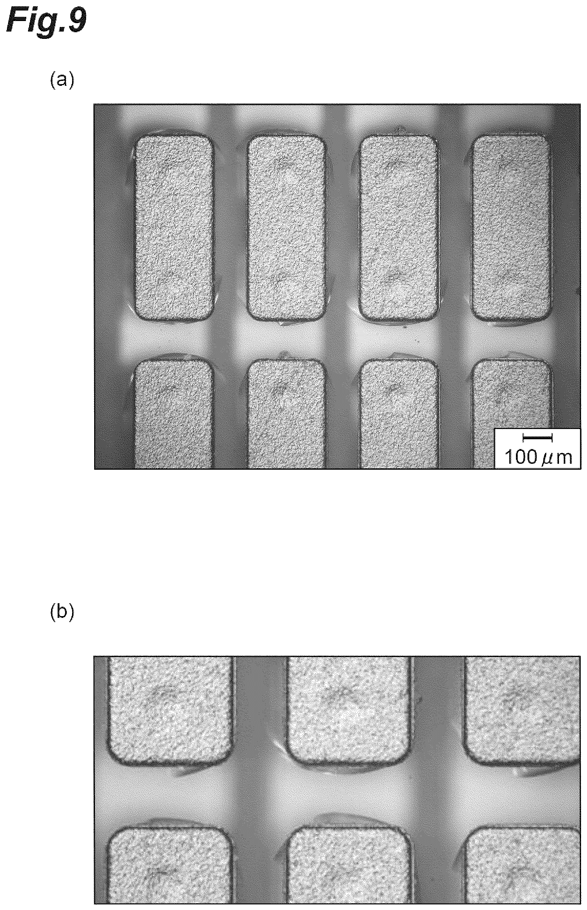

For the wiring boards produced in Example 12 and Comparative Example 7, the substrate surface after the temperature cycle test (50 times) was observed with an optical microscope. In the wiring board produced in Example 12, as illustrated in (a) of FIG. 8, the occurrence of cracks was suppressed even after the temperature cycle test. (b) of FIG. 8 is an enlarged view of a part of (a) of FIG. 8. On the other hand, in the wiring board produced in Comparative Example 7, as illustrated in (a) of FIG. 9, cracks occur in the glass substrate in the peripheral portion of the conductive via. (b) of FIG. 9 is an enlarged view of a part of (a) of FIG. 9.

### [Young's Modulus of Sintered Body of Metal Paste]

For the metal paste of Preparation Example A, a Young's modulus of the sintered body was measured by the following method.

### (Measurement of Young's Modulus)

The metal paste was applied onto a glass substrate so that the size after drying was 40 mm × 10 mm × 0.22 mm. Next, the coating of the metal paste was fired according to the following procedure.
(a) The glass substrate provided with the coating of the metal paste was placed in a tube furnace (manufactured by AVC Co., LTD.), and argon gas was flowed at 1 L/min to replace air in the tube furnace with argon gas.
(b) Next, the temperature was increased to 300°C for 10 minutes while hydrogen gas was flowed at 300 mL/min, and a sintering treatment was performed at 300°C for 60 minutes.
(c) Thereafter, argon gas was flowed at a flow rate of 0.3 L/min and cooled, and the glass substrate on which the sintered body was formed was taken out into the air at 50°C or lower.
(d) A Young's modulus of the obtained sintered body is measured by a resonance method using JE2-RT model manufactured by Nihon Techno-Plus Co., Ltd. under conditions of a temperature of 23°C and a resonance frequency of 278.4 Hz.

In the metal paste of Preparation Example A, the Young's modulus of the sintered body was 27.4 GPa. This value is about 1/3 of about 100 GPa, which is a Young's modulus of a general electrolytic copper plating coating. It is considered that, by filling the via with such a copper sintered body having a low Young's modulus, the stress at the periphery of the via can be reduced, and the occurrence of cracks at the periphery of the via can be suppressed after the temperature cycle test.

### [Production-2 of Conductive Via-Containing Glass Substrate]

### (Examples 14 to 45)

A conductive via-containing glass substrate was produced by the following procedure.

### [Preparation of Metal Paste]

### (Preparation Examples a to f)

Metal pastes were prepared by mixing the above and the following raw materials in the proportions shown in Table 6, respectively, using three rolls, and characteristics were confirmed in the same manner as described above.

### <Solder Particles>

Solder particles 1: SnBi58 solder STC-3 (manufactured by Mitsui MITSUI MINING & SMELTING CO., LTD., average particle diameter (D50): 4.1 µm, spherical shape)
Solder particles 2: Sn96.5Ag3Cu0.5 solder STC-3 (manufactured by MITSUI MINING & SMELTING CO., LTD., average particle diameter (D50): 4.1 µm, spherical shape)

### <Nickel Particles>

Nickel particles 1: nickel nanoparticles (manufactured by EM Japan Co., LTD., average particle diameter (D50): 0.1 µm, spherical shape)
Nickel particles 2: nickel particles (METAL FOIL & POWDERS MFG CO., average particle diameter (D50): 3.0 µm, spherical shape)

**[Table 6]**

| | | | | | Preparation Example a | Preparation Example b | Preparation Example c | Preparation Example d | Preparation Example e | Preparation Example f |
|---|---|---|---|---|---|---|---|---|---|---|
| Composition | Copper particle | First copper particle | Wet copper powder | Spherical copper particle W4 | 20 | - | 20 | 20 | 20 | - |
| | | | | Flat copper particle W2 | 20 | 50 | 20 | 20 | 20 | 20 |
| | | | Atomized copper powder | Spherical copper particle A2 | 20 | 10 | 20 | 20 | 20 | 20 |
| | | Second copper particle | Wet copper powder | Spherical copper particle W5 | 30 | 30 | 27 | 27 | 15 | 30 |
| | Solder particle | Solder particle 1 | | | - | - | 3 | - | - | - |
| | | Solder particle 2 | | | - | - | - | 3 | - | - |
| | Nickel particle | Nickel particle 1 | | | - | - | - | - | 15 | - |
| | | Nickel particle 2 | | | - | - | - | - | - | 20 |
| | Silver particle | Silver particle 1 | | | - | - | - | - | - | - |
| | | Silver particle 2 | | | - | - | - | - | - | - |
| | | Silver particle 3 | | | - | - | - | - | - | - |
| | Volatile solvent | High vapor pressure solvent | α-Terpineol (6.5 Pa) | | 2 | 2 | 2 | 2 | 2 | 2 |
| | | Low vapor pressure solvent | Diethylene glycol mono-n-butyl ether | | 2 | 2 | 2 | 2 | 2 | 2 |
| Content of metal particles in metal paste (% by mass) | | | | | 95.7 | 95.7 | 95.7 | 95.7 | 95.7 | 95.7 |
| Properties | Viscosity (Pa·s@25°C) | | | | 230 | 230 | 210 | 210 | 250 | 250 |
| | Printability | Determination | | | A | A | A | A | A | A |
| | | Coating amount (g) | | | 5.5 | 5.5 | 5.5 | 5.5 | 5.5 | 5.5 |
| | Bondability | Bonding strength with Cu (N) | | | 70 | 70 | 40 | 40 | 35 | 32 |
| | | Determination | | | A | A | B | B | C | C |
| | Volume resistivity (µΩ·cm) | | | | 3.8 | 3.8 | 7.3 | 8.6 | 7.6 | 8.9 |

### <Preparation of Glass Substrate>

A glass substrate "D263Teco" (manufactured by SCHOTT AG, trade name, material: borosilicate glass, average linear thermal expansion coefficient α: 7.2 × 10⁻⁶ K-1) including a through-hole and having a titanium layer (thickness 100 nm) and a copper layer (thickness 300 nm) formed in this order on both principal surfaces and on a wall surface of the through-hole was prepared. The glass substrate has a diameter of 6 inches and a thickness of 300 µm, and the titanium layer and the copper layer are sequentially formed by sputtering. Substrates provided with through-holes having hole diameters (via diameters) of 50, 90, 150, and 200 µm were prepared.

### <Production of Metal Particle Film>

The metal paste of Preparation Example a prepared as described above was printed on a PET film having a thickness of 100 µm with a screen printer in a size of 8-inch φ (circular shape with a diameter of 20 cm) using a screen printing plate (wire diameter: 23 µm, the number of meshes: 400, mesh size: 41 µm, and space ratio: 41 µm) to obtain a metal particle film provided with a metal particle-containing layer.

### <Formation of Conductive Via>

The metal particle film was bonded to the glass substrate from the metal particle-containing layer side with a bonding device VJ-35 (manufactured by Ayumi Industry Co., Ltd.), and the resulting laminate was further vacuum-pressed at room temperature and a pressure of 3 MPa to fill the through-holes with the metal paste. At this time, the metal paste was protruded from one side of the glass substrate opposite to the other side of the glass substrate on which the metal particle film was bonded.

Next, the PET film peeled off from the laminate was dried in the ambient atmosphere at 90°C for 10 minutes. The concentrations (% by mass) of the metal particles in the metal paste parts before and after drying were 95.7% by mass and 97.8% by mass, respectively.

For the dried laminate, as illustrated in (a) to (d) of FIG. 3, the metal paste on the main surface of the glass substrate on which the metal particle film was bonded was removed using a rubber squeegee, and subsequently, the metal paste protruding from one side of the glass substrate opposite to the other side of the glass substrate on which the metal particle film was bonded was removed using the rubber squeegee.

Next, the glass substrate having conductive via precursors formed in the through-holes by the above-described steps was placed in a tube furnace (manufactured by AVC Co., LTD.), and argon gas was flowed at a flow rate of 1 L/min to replace air in the tube furnace with argon gas. Thereafter, the temperature was increased to 300°C for 10 minutes while hydrogen gas was flowed at 300 mL/min, and a sintering treatment was performed at 300°C for 60 minutes to sinter the conductive via precursors. Thereafter, the resulting substrate was cooled while argon gas was flowed at a flow rate of 0.3 L/min and taken out into air at 50°C or lower to obtain a conductive via-containing glass substrate.

For the conductive via-containing glass substrate obtained as described above, the presence or absence of cracks and voids in the conductive vias and the recess after sintering was evaluated according to the above method.

### [Preparation of Wiring Board]

### (Examples 14 to 17)

A conductive via having a resin-containing portion containing a photosensitive resin composition was formed on a conductive via-containing glass substrate (via diameter: 50, 90, 150, or 200 µm) produced in the same manner as described above by the following procedure, and a wiring was further formed to obtain a wiring board, and an evaluation thereof was performed.

A dry film for an ultraviolet curable etching resist "RD-1619" (manufactured by Resonac Holdings Corporation, trade name) (photosensitive resin composition F1) was laminated on a surface of a metal sintered body-containing glass substrate obtained as described above under conditions of a roll pressure of 0.4 MPa, a processing temperature of 120°C, and a conveyance speed of 1.0 m/s by normal pressure lamination to form a dry film resist layer. Next, the dry film resist layer was exposed in a predetermined pattern using a direct drawing exposure machine "DE-1UH" (manufactured by Via Mechanics Co., Ltd. under a condition of 55 mJ/cm². After 1 minute therefrom, a PEB (post exposure bake) treatment was performed at 70°C for 1 minute, subsequently, a treatment was performed at a spray pressure of 0.17 MPa and 30°C for 70 seconds using a developer of sodium carbonate having a concentration of 1%, and further, a residue was removed by an oxygen plasma treatment, thereby forming a resist pattern. After the etching treatment (ammonium persulfate: 100 g/L, R.T., 30 seconds) and the surface treatment with a sulfuric acid aqueous solution (100 g/L, R.T., 30 sec), a resist opening was electrolytically plated. Thereafter, peeling of the resist and etching of the seed layer were performed to form a wiring having a wiring pattern of 300 µm × 600 µm, thereby obtaining a test piece 55 (wiring board) as illustrated in FIG. 5. The wiring pattern was finished so as to have a thickness of about 10 µm after etching of the seed layer. In the test piece 55, the conductive vias formed in the through-holes are electrically connected by the wiring provided on the substrate surface.

### (Examples 18 to 21)

Wiring boards were obtained in the same manner as in Examples 14 to 17, except that the roll pressure of the dry film "RD-1619" was changed to 1.0 MPa, and an evaluation thereof was performed.

### (Examples 22 to 25)

Wiring boards were obtained in the same manner as in Examples 14 to 17, except that the roll pressure of the dry film "RD-1619" was changed to 3.0 MPa, and an evaluation thereof was performed.

### (Examples 26 to 29)

A conductive via having a resin-containing portion containing a cured product of a photosensitive resin composition was formed on a metal sintered body-containing glass substrate (via diameter: 50, 90, 150, or 200 µm) produced in the same manner as described above by the following procedure, and a wiring was further formed to obtain a wiring board, and an evaluation thereof was performed.

A photosensitive film type TMMF NA1000 (manufactured by TOKYO OHKA KOGYO CO., LTD., trade name) (photosensitive resin composition F2) was laminated on the surface of the conductive via-containing glass substrate obtained as described above under conditions of a roll pressure of 1.0 MPa, a processing temperature of 120°C, and a conveyance speed of 1.0 m/s by normal pressure lamination to form a dry film resist layer. Next, a PEB treatment was performed at 80°C for 5 minutes, and subsequently, a treatment was performed at a spray pressure of 0.17 MPa and 30°C for 1 minute using PEGMEA (developer) to peel off the entire dry film resist layer formed on the surface of the glass substrate. Next, a heat treatment was performed at 200°C for 2 minutes to cure the photosensitive resin composition (TMMF NA1000) with which the porous portion of the copper sintered body was impregnated. Further, the residue of the photosensitive resin composition remaining on the surface of the copper sintered body and the cured product thereof was removed by an oxygen plasma treatment.

### [Wiring Forming Step A]

A dry film for an ultraviolet curable etching resist "RD-1619" (manufactured by Resonac Holdings Corporation, trade name) was laminated on a surface of a conductive via-containing glass substrate obtained as described above under conditions of a roll pressure of 0.4 MPa, a processing temperature of 120°C, and a conveyance speed of 1.0 m/s by normal pressure lamination to form a dry film resist layer. Next, the dry film resist layer was exposed in a predetermined pattern using a direct drawing exposure machine "DE-1UH" (manufactured by Via Mechanics Co., Ltd. under a condition of 55 mJ/cm². After 1 minute therefrom, a PEB treatment was performed at 70°C for 1 minute, subsequently, a treatment was performed at a spray pressure of 0.17 MPa and 30°C for 70 seconds using a developer of sodium carbonate having a concentration of 1%, and further, a residue was removed by an oxygen plasma treatment, thereby forming a resist pattern. Next, electrolytic plating was performed on opening portions of the resist, and peeling of the resist and etching of the seed layer were then performed to form a wiring having a wiring pattern of 300 µm × 600 µm, thereby obtaining a test piece 55 (wiring board) as illustrated in FIG. 5. The wiring pattern was finished so as to have a thickness of about 10 µm after etching of the seed layer. In the test piece 55, the conductive vias formed in the through-holes are electrically connected by the wiring provided on the substrate surface.

### (Examples 30 to 33)

A conductive via having a resin-containing portion containing a cured product of a photosensitive resin composition was formed on a conductive via-containing glass substrate (via diameter: 50, 90, 150, or 200 µm) produced in the same manner as described above by the following procedure, and a wiring was further formed to obtain a wiring board, and an evaluation thereof was performed.

On the surface of the conductive via-containing glass substrate obtained as described above, developed dry film solder resist PSR-800 AUS SR-1 (manufactured by Taiyo Ink Mfg. Co., Ltd., trade name) (photosensitive resin composition F3) was laminated with a vacuum laminate MVLP series (manufactured by The Japan Steel Works, LTD., trade name) under conditions of a vacuum degree of 3 hPa, a cycle time of 30 seconds, 100°C, 0.5 MPa, and a cycle time of 30 seconds, and then pressed under the conditions of 80°C, 0.8 MPa, and a cycle time of 60 seconds. Next, a development treatment was performed with a 1% by mass sodium carbonate solution under conditions of 30°C and a spray pressure 0.15 MPa for 1 minute, and washing with water was performed under conditions of 25°C and a spray pressure 0.10 MPa for 1 minute. The dry film resist layer formed on the surface of the glass substrate was entirely peeled off. Next, post-cure was performed under a condition of 150°C for 60 minutes to cure the photosensitive resin composition (PSR-800 AUS SR-1) with which the porous portion of the copper sintered body was impregnated. Further, the residue of the photosensitive resin composition remaining on the surface of the copper sintered body and the cured product thereof was removed by an oxygen plasma treatment.

On the surface of the conductive via-containing glass substrate obtained above, a wiring was formed in the same manner as in the wiring forming step A to obtain a test piece 55 (wiring board) as illustrated in FIG. 5.

### (Examples 34 to 37)

A conductive via having a resin-containing portion containing a cured product of a photosensitive resin composition was formed on a conductive via-containing glass substrate (via diameter: 50, 90, 150, or 200 µm) produced in the same manner as described above by the following procedure, and a wiring was further formed to obtain a wiring board, and an evaluation thereof was performed.

On the surface of the conductive via-containing glass substrate obtained above, a solder resist for developing-type screen printing PSR-4000 G24K/CA-40 G24 (manufactured by Taiyo Ink Mfg. Co., Ltd., trade name) (photosensitive resin composition L1) was printed, by a screen printer, on one surface so as to have a thickness of about 20 µm. After temporary drying was performed at 80°C for 30 minutes, printing was similarly performed on the opposite surface by a screen printer so as to have a thickness of about 20 µm, and temporary drying was performed at 80°C for 30 minutes. Next, a development treatment was performed with a 1% by mass sodium carbonate solution under conditions of 30°C and a spray pressure 0.15 MPa for 1 minute, and washing with water was performed under conditions of 25°C and a spray pressure 0.10 MPa for 1 minute. The solder resist layer formed on the surface of the glass substrate was entirely peeled off. Next, post-cure was performed under a condition of 150°C for 60 minutes to cure the photosensitive resin composition (PSR-4000 G24K/CA-40 G24) with which the porous portion of the copper sintered body was impregnated. Further, the residue of the photosensitive resin composition remaining on the surface of the copper sintered body and the cured product thereof was removed by an oxygen plasma treatment.

On the surface of the conductive via-containing glass substrate obtained above, a wiring was formed in the same manner as in the wiring forming step A to obtain a test piece 55 (wiring board) as illustrated in FIG. 5.

### (Examples 38 to 41)

A conductive via having a resin-containing portion containing a cured product of a photosensitive resin composition was formed on a conductive via-containing glass substrate (via diameter: 50, 90, 150, or 200 µm) produced in the same manner as described above by the following procedure, and a wiring was further formed to obtain a wiring board, and an evaluation thereof was performed.

The positive photosensitive resin AH-3000 (manufactured by Resonac Holdings Corporation, trade name) (photosensitive resin composition L2) was applied to one surface of the conductive via-containing glass substrate obtained as described above by spin coating at 1000 rpm/5 seconds and 2000 rpm/20 seconds so as to have a thickness of about 5 µm. After temporary drying was performed at 120°C for 150 seconds, the opposite surface was also treated by spin coating at 1000 rpm/5 seconds and 2000 rpm/20 seconds in the same manner so as to have a thickness of about 5 µm. Both surfaces of the substrate were exposed to light using a direct drawing exposure machine "DE-1UH" (manufactured by Via Mechanics Co., Ltd., product number) under a condition of 500 mJ/cm². Subsequently, a treatment was performed at a spray pressure of 0.17 MPa and 30°C for 1 minute using 2.38%-TMAH (developer) to peel off the entire surface of the positive photosensitive resin composition layer formed on the surface of the glass substrate. Next, a heat treatment was performed at 230°C for 60 minutes to cure the positive photosensitive resin composition (AH-3000) with which the porous portion of the copper sintered body was impregnated. Further, the residue of the photosensitive resin composition remaining on the surface of the copper sintered body and the cured product thereof was removed by an oxygen plasma treatment.

On the surface of the conductive via-containing glass substrate obtained above, a wiring was formed in the same manner as in the wiring forming step A to obtain a test piece 55 (wiring board) as illustrated in FIG. 5.

### (Examples 42 to 45)

A conductive via having a resin-containing portion containing a cured product of a photosensitive resin composition was formed on a metal sintered body-containing glass substrate (via diameter: 50, 90, 150, or 200 µm) produced in the same manner as described above by the following procedure, and a wiring was further formed to obtain a wiring board, and an evaluation thereof was performed.

The positive photosensitive resin AH-3000 (manufactured by Resonac Holdings Corporation, trade name) (photosensitive resin composition L2) was applied to one surface of the conductive via-containing glass substrate obtained as described above by spin coating at 1000 rpm/5 seconds so as to have a thickness of about 20 µm. Thereafter, vacuuming was performed so that the degree of vacuum was 3 hPa to impregnate the porous portion of the copper sintered body with the positive photosensitive resin composition (AH-3000). Temporary drying was performed at 120°C for 150 seconds. The opposite surface was also treated by spin coating at 1000 rpm/5 seconds in the same manner so as to have a thickness of about 20 µm. Thereafter, vacuuming was performed so that the degree of vacuum was 3 hPa to impregnate the porous portion of the copper sintered body with the positive photosensitive resin composition (AH-3000). Further, temporary drying was performed at 120°C for 150 seconds. Both surfaces of the substrate were exposed to light using a direct drawing exposure machine "DE-1UH" (manufactured by Via Mechanics Co., Ltd., product number) under a condition of 500 mJ/cm². Subsequently, a treatment was performed at a spray pressure of 0.17 MPa and 30°C for 1 minute using 2.38%-TMAH (developer) to peel off the entire surface of the positive photosensitive resin resin composition layer formed on the surface of the glass substrate. Next, a heat treatment was performed at 230°C for 60 minutes to cure the positive photosensitive resin composition (AH-3000) with which the porous portion of the copper sintered body was impregnated. Further, the residue of the photosensitive resin composition remaining on the surface of the copper sintered body and the cured product thereof was removed by an oxygen plasma treatment.

On the surface of the conductive via-containing glass substrate obtained above, a wiring was formed in the same manner as in the wiring forming step A to obtain a test piece 55 (wiring board) as illustrated in FIG. 5.

### [Impregnation Depth of Photosensitive Resin Composition into Porous Portion of Metal Sintered Body]

The cross section of the conductive via of the conductive via-containing glass substrate was exposed by cross section polishing, the surface was cleaned by ion milling, and the cross section was observed. Using a scanning electron microscope S-3700N (manufactured by Hitachi High-Technologies Corporation), the impregnation depth of the photosensitive resin composition (or the cured product thereof) into the porous portion was measured. The distance from the via surface to the porous (pore) portion was measured at 10 points, and the average value thereof was taken as the impregnation depth.

### [Evaluation of Wiring Board]

For the test piece obtained as described above, the initial resistance value, the connection reliability, and the recess on the surface of the wiring pattern formed on the conductive via were evaluated according to the following methods.

### <Initial Resistance Value>

As an initial resistance value of the test piece 55 (wiring board), a resistance value in which 1000 vias were connected was measured. The initial resistance value was evaluated based on this interconnection resistance value according to the following criteria.

### (Number of Vias)

1000 pieces

### (Criteria)

A: Resistance value is less than 6 Ω.
B: Resistance value is 6 Ω or more and less than 10 Ω.
C: Resistance value is 10 Ω or more and less than 20 Ω.
D: Resistance value is 20 Ω or more and less than 50 Ω.
E: Resistance value is 50 Ω or more.

### <Connection Reliability-Temperature Cycle Test>

The test piece 55 (wiring board) was set in a temperature cycle tester (TSA-72SE-W, manufactured by ESPEC CORP.), and a temperature cycle connection reliability test was performed under the conditions of low temperature side: -55°C, 15 minutes, room temperature: 2 minutes, high temperature side: 125°C, 15 minutes, defrosting cycle: automatic, and the number of cycles: 50, 100, 300, 500, and 1000 cycles. For the test piece after undergoing each of the number of cycles, a resistance value in which the vias of the number described above were connected was measured. The connection reliability was evaluated based on this interconnection resistance value according to the following criteria.

### (Criteria)

A: Resistance change rate is less than 1% with respect to initial resistance value.
B: Resistance change rate is 1% or more and less than 3% with respect to initial resistance value.
C: Resistance change rate is 3% or more and less than 5% with respect to initial resistance value.
D: Resistance change rate is 5% or more and less than 10% with respect to initial resistance value.
E: Resistance change rate is 10% or more and less than 20% with respect to initial resistance value.
F: Resistance change rate is 20% or more with respect to initial resistance value.
G: A conduction failure occurs.

### <Connection Reliability-150°C>

The test piece 55 was set in a high temperature tank (precision incubator DH612, manufactured by Yamato Scientific co., ltd.), left standing at 150°C for 50, 100, 300, and 500 hours, and a high temperature leaving test was performed. For the test piece after each time, a resistance value in which the vias of the number described above were connected was measured. The connection reliability was evaluated based on this interconnection resistance value according to the following criteria.

### (Criteria)

A: Resistance change rate is less than 1% with respect to initial resistance value.
B: Resistance change rate is 1% or more and less than 3% with respect to initial resistance value.
C: Resistance change rate is 3% or more and less than 5% with respect to initial resistance value.
D: Resistance change rate is 5% or more and less than 10% with respect to initial resistance value.
E: Resistance change rate is 10% or more and less than 20% with respect to initial resistance value.
F: Resistance change rate is 20% or more with respect to initial resistance value.
G: A conduction failure occurs.

### <Connection Reliability-200°C>

The test piece 55 was set in a high temperature tank (precision incubator DH612, manufactured by Yamato Scientific co., ltd.), left standing at 200°C for 50, 100, 300, and 500 hours, and a high temperature leaving test was performed. For the test piece after each time, a resistance value in which the vias of the number described above were connected was measured. The connection reliability was evaluated based on this interconnection resistance value according to the following criteria.

### (Criteria)

A: Resistance change rate is less than 1% with respect to initial resistance value.
B: Resistance change rate is 1% or more and less than 3% with respect to initial resistance value.
C: Resistance change rate is 3% or more and less than 5% with respect to initial resistance value.
D: Resistance change rate is 5% or more and less than 10% with respect to initial resistance value.
E: Resistance change rate is 10% or more and less than 20% with respect to initial resistance value.
F: Resistance change rate is 20% or more with respect to initial resistance value.
G: A conduction failure occurs.

### <Recess on Surface of Wiring Pattern Formed on Conductive Via>

The surface of the wiring pattern formed on the conductive via of the test piece 55 (wiring board) was observed for 30 conductive vias using a digital microscope (VHX-6000, manufactured by KEYENCE CORPORATION), the deepest portion was measured, and the average value thereof was taken as the recess on the surface of the wiring pattern.

### (Criteria)

A: Mean value of average step heights is less than 2 µm
B: Mean value of average step heights is 2 µm or more and less than 4 µm
C: Mean value of average step heights is 4 µm or more and less than 6 µm
D: Mean value of average step heights is 6 µm or more and less than 8 µm
E: Mean value of average step heights is 8 µm or more

**[Table 7]**

| | | | Example 14 | Example 15 | Example 16 | Example 17 |
|---|---|---|---|---|---|---|
| Metal paste | | | Preparation Example a | Preparation Example a | Preparation Example a | Preparation Example a |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.7 | 2.3 | 3.8 | 4.5 |
| | | Determination | B | B | C | C |
| | Recess after resist peeling | (µm) | 1.9 | 2.9 | 4.3 | 5.3 |
| | | Determination | B | B | C | D |
| | Porosity of conductive via (%) | | 4 | 4 | 4 | 4 |
| Photosensitive resin composition | | | F1 | F1 | F1 | F1 |
| Impregnation depth of photosensitive resin composition into metal sintered body (µm) | | | 2 | 2 | 2 | 2 |
| Wiring board | Recess on surface of wiring pattern formed on conductive via (µm) | | A | A | A | A |
| | Initial resistance value | | A | A | A | A |
| | After reliability test (temperature cycle) | 50 times | A | A | B | B |
| | | 100 times | A | A | B | B |
| | | 300 times | A | A | B | B |
| | | 500 times | A | A | B | B |
| | | 1000 times | A | A | B | B |
| | After reliability test (150°C) | 50 hours | A | A | B | B |
| | | 100 hours | A | A | B | B |
| | | 300 hours | B | B | C | C |
| | | 500 hours | B | B | C | C |
| | After reliability test (200°C) | 50 hours | A | A | B | B |
| | | 100 hours | A | A | B | B |
| | | 300 hours | B | B | C | C |
| | | 500 hours | B | B | C | C |

**[Table 8]**

| | | | Example 18 | Example 19 | Example 20 | Example 21 |
|---|---|---|---|---|---|---|
| Metal paste | | | Preparation Example a | Preparation Example a | Preparation Example a | Preparation Example a |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.7 | 2.3 | 3.8 | 4.5 |
| | | Determination | B | B | C | C |
| | Recess after resist peeling | (µm) | 2.1 | 3.1 | 4.6 | 5.3 |
| | | Determination | B | C | C | D |
| | Porosity of conductive via (%) | | 4 | 4 | 4 | 4 |
| Photosensitive resin composition | | | F1 | F1 | F1 | F1 |
| Impregnation depth of photosensitive resin composition into metal sintered body (µm) | | | 4 | 4 | 4 | 4 |
| Wiring board | Recess on surface of wiring pattern formed on conductive via (µm) | | A | A | A | A |
| | Initial resistance value | | A | A | A | A |
| | After reliability test (temperature cycle) | 50 times | A | A | A | A |
| | | 100 times | A | A | A | A |
| | | 300 times | A | A | A | B |
| | | 500 times | A | A | A | B |
| | | 1000 times | A | A | A | B |
| | After reliability test (150°C) | 50 hours | A | A | A | B |
| | | 100 hours | A | A | A | B |
| | | 300 hours | B | B | B | B |
| | | 500 hours | B | B | B | B |
| | After reliability test (200°C) | 50 hours | A | A | A | B |
| | | 100 hours | A | A | A | B |
| | | 300 hours | B | B | B | B |
| | | 500 hours | B | B | B | B |

**[Table 9]**

| Example 22 Example 23 Example 24 Example 25 | | | | | | |
|---|---|---|---|---|---|---|
| Metal paste | | | Preparation Example a | Preparation Example a | Preparation Example a | Preparation Example a |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.7 | 2.3 | 3.8 | 4.5 |
| | | Determination | B | B | C | C |
| | Recess after resist peeling | (µm) | 2.3 | 2.9 | 4.4 | 5.3 |
| | | Determination | B | B | C | D |
| | Porosity of conductive via (%) | | 4 | 4 | 4 | 4 |
| Photosensitive resin composition | | | F1 | F1 | F1 | F1 |
| Impregnation depth of photosensitive resin composition into metal sintered body (µm) | | | 7 | 7 | 7 | 7 |
| Wiring board | Recess on surface of wiring pattern formed on conductive via (µm) | | A | A | A | A |
| | Initial resistance value | | A | A | A | A |
| | After reliability test (temperature cycle) | 50 times | A | A | A | A |
| | | 100 times | A | A | A | A |
| | | 300 times | A | A | A | A |
| | | 500 times | A | A | A | A |
| | | 1000 times | A | A | A | A |
| | After reliability test (150°C) | 50 hours | A | A | A | A |
| | | 100 hours | A | A | A | A |
| | | 300 hours | B | B | B | B |
| | | 500 hours | B | B | B | B |
| | After reliability test (200°C) | 50 hours | A | A | A | A |
| | | 100 hours | A | A | A | A |
| | | 300 hours | B | B | B | B |
| | | 500 hours | B | B | B | B |

**[Table 10]**

| | | | Example 26 | Example 27 | Example 28 | Example 29 |
|---|---|---|---|---|---|---|
| Metal paste | | | Preparation Example a | Preparation Example a | Preparation Example a | Preparation Example a |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.7 | 2.3 | 3.8 | 4.5 |
| | | Determination | B | B | C | C |
| | Recess after resist peeling | (µm) | 2.3 | 2.8 | 4.3 | 5.3 |
| | | Determination | B | B | C | D |
| | Porosity of conductive via (%) | | 4 | 4 | 4 | 4 |
| Photosensitive resin composition | | | F2 | F2 | F2 | F2 |
| Impregnation depth of photosensitive resin composition into metal sintered body (µm) | | | 7 | 7 | 7 | 7 |
| Wiring board | Recess on surface of wiring pattern formed on conductive via (µm) | | A | A | A | A |
| | Initial resistance value | | A | A | A | A |
| | After reliability test (temperature cycle) | 50 times | A | A | A | A |
| | | 100 times | A | A | A | A |
| | | 300 times | A | A | A | A |
| | | 500 times | A | A | A | A |
| | | 1000 times | A | A | A | A |
| | After reliability test (150°C) | 50 hours | A | A | A | A |
| | | 100 hours | A | A | A | A |
| | | 300 hours | A | A | A | A |
| | | 500 hours | A | A | A | A |
| | After reliability test (200°C) | 50 hours | A | A | A | A |
| | | 100 hours | A | A | A | A |
| | | 300 hours | B | B | B | B |
| | | 500 hours | B | B | B | B |

**[Table 11]**

| | | | Example 30 | Example 31 | Example 32 | Example 33 |
|---|---|---|---|---|---|---|
| Metal paste | | | Preparation Example a | Preparation Example a | Preparation Example a | Preparation Example a |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.7 | 2.3 | 3.8 | 4.5 |
| | | Determination | B | B | C | C |
| | Recess after resist peeling | (µm) | 2.2 | 2.7 | 4.3 | 5.4 |
| | | Determination | B | B | C | D |
| | Porosity of conductive via (%) | | 4 | 4 | 4 | 4 |
| Photosensitive resin composition | | | F3 | F3 | F3 | F3 |
| Impregnation depth of photosensitive resin composition into metal sintered body (µm) | | | 14 | 14 | 14 | 14 |
| Wiring board | Recess on surface of wiring pattern formed on conductive via (µm) | | A | A | A | A |
| | Initial resistance value | | A | A | A | A |
| | After reliability test (temperature cycle) | 50 times | A | A | A | A |
| | | 100 times | A | A | A | A |
| | | 300 times | A | A | A | A |
| | | 500 times | A | A | A | A |
| | | 1000 times | A | A | A | A |
| | After reliability test (150°C) | 50 hours | A | A | A | A |
| | | 100 hours | A | A | A | A |
| | | 300 hours | A | A | A | A |
| | | 500 hours | A | A | A | A |
| | After reliability test (200°C) | 50 hours | A | A | A | A |
| | | 100 hours | A | A | A | A |
| | | 300 hours | B | B | B | B |
| | | 500 hours | B | B | B | B |

**[Table 12]**

| | | | Example 34 | Example 35 | Example 36 | Example 37 |
|---|---|---|---|---|---|---|
| Metal paste | | | Preparation Example a | Preparation Example a | Preparation Example a | Preparation Example a |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.7 | 2.3 | 3.8 | 4.5 |
| | | Determination | B | B | C | C |
| | Recess after resist peeling | (µm) | 2.4 | 2.9 | 4.4 | 5.4 |
| | | Determination | B | B | C | D |
| | Porosity of conductive via (%) | | 4 | 4 | 4 | 4 |
| Photosensitive resin composition | | | L1 | L1 | L1 | L1 |
| Impregnation depth of photosensitive resin composition into metal sintered body (µm) | | | 50 | 50 | 50 | 50 |
| Wiring board | Recess on surface of wiring pattern formed on conductive via (µm) | | A | A | A | A |
| | Initial resistance value | | A | A | A | A |
| | After reliability test (temperature cycle) | 50 times | A | A | A | A |
| | | 100 times | A | A | A | A |
| | | 300 times | A | A | A | A |
| | | 500 times | A | A | A | A |
| | | 1000 times | A | A | A | A |
| | After reliability test (150°C) | 50 hours | A | A | A | A |
| | | 100 hours | A | A | A | A |
| | | 300 hours | A | A | A | A |
| | | 500 hours | A | A | A | A |
| | After reliability test (200°C) | 50 hours | A | A | A | A |
| | | 100 hours | A | A | A | A |
| | | 300 hours | B | B | B | B |
| | | 500 hours | B | B | B | B |

**[Table 13]**

| | | | Example 38 | Example 39 | Example 40 | Example 41 |
|---|---|---|---|---|---|---|
| Metal paste | | | Preparation Example a | Preparation Example a | Preparation Example a | Preparation Example a |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.7 | 2.3 | 3.8 | 4.5 |
| | | Determination | B | B | c | c |
| | Recess after resist peeling | (µm) | 1.9 | 2.6 | 3.9 | 4.6 |
| | | Determination | B | B | c | c |
| | Porosity of conductive via (%) | | 4 | 4 | 4 | 4 |
| Photosensitive resin composition | | | L2 | L2 | L2 | L2 |
| Impregnation depth of photosensitive resin composition into metal sintered body (µm) | | | 50 | 50 | 50 | 50 |
| Wiring board | Recess on surface of wiring pattern formed on conductive via (µm) | | A | A | A | A |
| | Initial resistance value | | A | A | A | A |
| | After reliability test (temperature cycle) | 50 times | A | A | A | A |
| | | 100 times | A | A | A | A |
| | | 300 times | A | A | A | A |
| | | 500 times | A | A | A | A |
| | | 1000 times | A | A | A | A |
| | After reliability test (150°C) | 50 hours | A | A | A | A |
| | | 100 hours | A | A | A | A |
| | | 300 hours | A | A | A | A |
| | | 500 hours | A | A | A | A |
| | After reliability test (200°C) | 50 hours | A | A | A | A |
| | | 100 hours | A | A | A | A |
| | | 300 hours | B | B | B | B |
| | | 500 hours | B | B | B | B |

**[Table 14]**

| | | | Example 42 | Example 43 | Example 44 | Example 45 |
|---|---|---|---|---|---|---|
| Metal paste | | | Preparation Example a | Preparation Example a | Preparation Example a | Preparation Example a |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.7 | 2.3 | 3.8 | 4.5 |
| | | Determination | B | B | C | C |
| | Recess after resist peeling | (µm) | 2 | 2.8 | 3.9 | 4.9 |
| | | Determination | B | B | C | D |
| | Porosity of conductive via (%) | | 4 | 4 | 4 | 4 |
| Photosensitive resin composition | | | L2 | L2 | L2 | L2 |
| Impregnation depth of photosensitive resin composition into metal sintered body (µm) | | | Entire impregnation | Entire impregnation | Entire impregnation | Entire impregnation |
| Wiring board | Recess on surface of wiring pattern formed on conductive via (µm) | | A | A | A | A |
| | Initial resistance value | | A | A | A | A |
| | After reliability test (temperature cycle) | 50 times | A | A | A | A |
| | | 100 times | A | A | A | A |
| | | 300 times | A | A | A | A |
| | | 500 times | A | A | A | A |
| | | 1000 times | A | A | A | A |
| | After reliability test (150°C) | 50 hours | A | A | A | A |
| | | 100 hours | A | A | A | A |
| | | 300 hours | A | A | A | A |
| | | 500 hours | A | A | A | A |
| | After reliability test (200°C) | 50 hours | A | A | A | A |
| | | 100 hours | A | A | A | A |
| | | 300 hours | B | B | B | B |
| | | 500 hours | B | B | B | B |

### (Examples 46 to 49)

A conductive via-containing glass substrate was produced in the same manner as in Examples 14 to 17, except that the metal paste of Preparation Example b was used, and evaluation was performed in the same manner as described above. The concentrations (% by mass) of the metal particles in the metal paste parts before and after drying were 95.7% by mass and 97.8% by mass, respectively.

Wiring boards were obtained in the same manner as in Examples 14 to 17, except that the conductive via-containing glass substrate produced as described above was used, the roll pressure of the dry film "RD-1619" was changed to 3.0 MPa, and an evaluation thereof was performed.

### (Example 50)

A conductive via-containing glass substrate was produced in the same manner as in Example 16, except that the metal paste of Preparation Example c was used, and evaluation was performed in the same manner as described above. The concentrations (% by mass) of the metal particles in the metal paste parts before and after drying were 95.7% by mass and 97.8% by mass, respectively.

Wiring boards were obtained in the same manner as in Example 16, except that the conductive via-containing glass substrate produced as described above was used, the roll pressure of the dry film "RD-1619" was changed to 3.0 MPa, and an evaluation thereof was performed.

### (Example 51)

A conductive via-containing glass substrate was produced in the same manner as in Example 16, except that the metal paste of Preparation Example d was used, and evaluation was performed in the same manner as described above. The concentrations (% by mass) of the metal particles in the metal paste parts before and after drying were 95.7% by mass and 97.8% by mass, respectively.

Wiring boards were obtained in the same manner as in Example 16, except that the conductive via-containing glass substrate produced as described above was used, the roll pressure of the dry film "RD-1619" was changed to 3.0 MPa, and an evaluation thereof was performed.

### (Example 52)

A conductive via-containing glass substrate was produced in the same manner as in Example 16, except that the metal paste of Preparation Example e was used, and evaluation was performed in the same manner as described above. The concentrations (% by mass) of the metal particles in the metal paste parts before and after drying were 95.7% by mass and 97.8% by mass, respectively.

A wiring board was obtained in the same manner as in Example 16, except that the conductive via-containing glass substrate produced above was used, and an evaluation thereof was performed.

### (Example 53)

A conductive via-containing glass substrate was produced in the same manner as in Example 16, except that the metal paste of Preparation Example f was used, and evaluation was performed in the same manner as described above. The concentrations (% by mass) of the metal particles in the metal paste parts before and after drying were 95.7% by mass and 97.8% by mass, respectively.

A wiring board was obtained in the same manner as in Example 16, except that the conductive via-containing glass substrate produced above was used, and an evaluation thereof was performed.

**[Table 15]**

| | | | Example 46 | Example 47 | Example 48 | Example 49 |
|---|---|---|---|---|---|---|
| Metal paste | | | Preparation Example b | Preparation Example b | Preparation Example b | Preparation Example b |
| Substrate | | Material | Glass | Glass | Glass | Glass |
| | | Type of hole | Through | Through | Through | Through |
| | | Via diameter (µm) | 50 | 90 | 150 | 200 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 2.4 | 3.3 | 4.2 | 4.9 |
| | | Determination | B | C | C | C |
| | Recess after resist peeling | (µm) | 3.3 | 3.6 | 5.3 | 6.3 |
| | | Determination | C | C | D | D |
| | Porosity of conductive via (%) | | 10 | 10 | 10 | 10 |
| Photosensitive resin composition | | | F1 | F1 | F1 | F1 |
| Impregnation depth of photosensitive resin composition into metal sintered body (µm) | | | 7 | 7 | 7 | 7 |
| Wiring board | Recess on surface of wiring pattern formed on conductive via (µm) | | A | A | A | A |
| | Initial resistance value | | A | A | A | A |
| | After reliability test (temperature cycle) | 50 times | A | A | A | A |
| | | 100 times | A | A | A | A |
| | | 300 times | A | A | A | A |
| | | 500 times | A | A | A | A |
| | | 1000 times | A | A | A | A |
| | After reliability test (150°C) | 50 hours | A | A | A | A |
| | | 100 hours | A | A | A | A |
| | | 300 hours | B | B | B | B |
| | | 500 hours | B | B | B | B |
| | After reliability test (200°C) | 50 hours | A | A | A | A |
| | | 100 hours | A | A | A | A |
| | | 300 hours | B | B | B | B |
| | | 500 hours | B | B | B | B |

**[Table 16]**

| | | | Example 50 | Example 51 | Example 52 | Example 53 |
|---|---|---|---|---|---|---|
| Metal paste | | | Preparation Example c | Preparation Example d | Preparation Example e | Preparation Example f |
| Substrate | | Material | Glass | Glass | Glass | Glass |
| | | Type of hole | Through | Through | Through | Through |
| | | Via diameter (µm) | 150 | 150 | 150 | 150 |
| | | Via depth (µm) | 300 | 300 | 300 | 300 |
| Conductive via | Crack | | Absent | Absent | Absent | Absent |
| | Void | | Absent | Absent | Absent | Absent |
| | Recess after sintering | (µm) | 1.9 | 2.5 | 3.9 | 4.6 |
| | | Determination | B | B | C | C |
| | Recess after resist peeling | (µm) | 2.5 | 3.2 | 4.2 | 5.5 |
| | | Determination | B | C | C | D |
| | Porosity of conductive via (%) | | 6 | 6 | 4 | 4 |
| Photosensitive resin composition | | | F1 | F1 | F1 | F1 |
| Impregnation depth of photosensitive resin composition into metal sintered body (µm) | | | 7 | 7 | 2 | 2 |
| Wiring board | Recess on surface of wiring pattern formed on conductive via (µm) | | A | A | A | A |
| | Initial resistance value | | B | B | B | B |
| | After reliability test (temperature cycle) | 50 times | A | A | A | A |
| | | 100 times | A | A | A | A |
| | | 300 times | A | A | A | A |
| | | 500 times | A | A | A | A |
| | | 1000 times | A | A | A | A |
| | After reliability test (150°C) | 50 hours | A | A | A | A |
| | | 100 hours | A | A | A | A |
| | | 300 hours | B | B | B | B |
| | | 500 hours | B | B | B | B |
| | After reliability test (200°C) | 50 hours | A | A | A | A |
| | | 100 hours | A | A | A | A |
| | | 300 hours | B | B | B | B |
| | | 500 hours | B | B | B | B |

### Reference Signs List

- 1: Glass base material
- 2: Metal coating
- 3: Metal paste part
- 3b: Conductive via precursor
- 3c: Conductive via
- 3p: Metal particle-containing layer
- 7: Support film
- 8a: Etching resist
- 9: Wiring
- 30: Through-hole
- 31: Blind-hole
- 40, 41: Glass substrate
- 42: Rubber squeegee
- 50: Conductive via-containing glass substrate
- 52: Conductive via-containing wiring board
- 55: Test piece
- A: Pressure jig

## Claims

1. A method for manufacturing a conductive via-containing glass substrate, the method comprising:
a step a of preparing a glass substrate provided with a hole and providing a metal paste part containing metal particles and a volatile solvent to fill the inside of the hole and cover at least a surface surrounding the hole of the glass substrate;
a step b of heating the metal paste part to remove a part of the volatile solvent;
a step c of removing a part of the metal paste part after heating to expose the surface to form a conductive via precursor in the hole, the conductive via precursor containing the metal particles and a residue of the volatile solvent and having a planarized exposed surface; and
a step d of firing the conductive via precursor,
wherein the metal particles include first metal particles having a volume average particle diameter of 0.8 µm or more and second metal particles having a volume average particle diameter of 0.5 µm or less,
a metal particle concentration of the metal paste part provided in the step a is 95.0% by mass or more, and
a content of the second metal particles in the metal paste part provided in the step a is 50% by mass or less based on a total amount of the metal particles.

2. The method for manufacturing a conductive via-containing glass substrate according to claim 1, wherein the first metal particles and the second metal particles are copper particles.

3. The method for manufacturing a conductive via-containing glass substrate according to claim 1 or 2, wherein the first metal particles include flaky copper particles.

4. A metal paste for forming a through glass via, the metal paste comprising:
metal particles; and
a volatile solvent,
wherein a content of the metal particles is 95.0% by mass or more based on a total amount of the metal paste,
the metal particles include first metal particles having a volume average particle diameter of 0.8 µm or more and second metal particles having a volume average particle diameter of 0.5 µm or less, and
a content of the second metal particles is 50% by mass or less based on a total amount of the metal particles.

5. The metal paste for forming a through glass via according to claim 4, wherein the first metal particles and the second metal particles are copper particles.

6. The metal paste for forming a through glass via according to claim 4 or 5, wherein the first metal particles include flaky copper particles.

7. A conductive via-containing glass substrate comprising:
a glass substrate having a through-hole; and
a conductive via provided in the through-hole,
wherein the conductive via contains a sintered body of the metal paste according to claim 4 or 5.
